# EUROPEAN PATENT APPLICATION

(11) **EP 4 432 011 A1**
(43) Date of publication of application: **18.09.2024**
(21) Application number: 24162134.1
(22) Date of filing: 07.03.2024
(51) Int. Cl.: G03F 7/09, G03F 7/075

(54) **METHOD FOR FORMING RESIST UNDERLAYER FILM AND PATTERING PROCESS**

(30) Priority: 13.03.2023 JP 2023038307; 01.12.2023 JP 2023204015
(71) Applicant: SHIN-ETSU CHEMICAL CO., LTD., Tokyo 1000005 (JP)
(72) Inventor: KOBAYASHI, Naoki, Niigata (JP); NAGAMACHI, Nobuhiro, Niigata, Niigata (JP); ISHIWATA, Kenta, Niigata (JP); KORI, Daisuke, Niigata (JP)
(74) Representative: Sonnenhauser, Thomas Martin

(57) **Abstract**

The present invention is a method for forming a resist underlayer film, including: a coating step of coating a substrate with a composition for forming a resist underlayer film containing a metal compound having a metal-oxygen covalent bond and an organic solvent; and a heating step of heating the coated substrate in an atmosphere having an oxygen concentration of less than 1 volume % at a temperature of 450°C or higher and 800°C or lower, where a compound containing at least one crosslinking group represented by the following general formulae (a-1) to (a-4), (b-1) to (b-4), and (c-1) to (c-3) is used as the metal compound. This provides: a method for forming a resist underlayer film that contains metal and that exhibits both high filling property and high dry etching resistance; and a patterning process using the method.

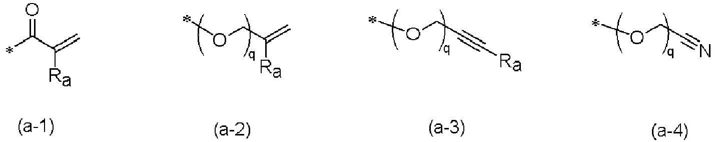

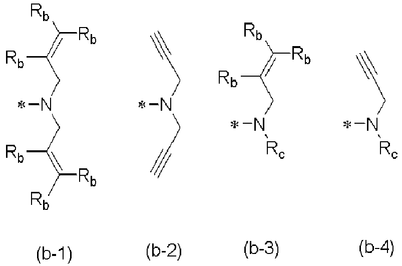

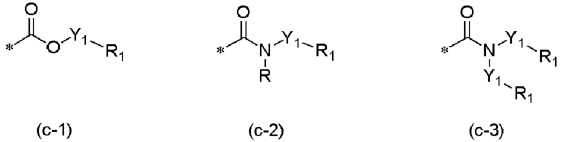

## Description

### TECHNICAL FIELD

The present invention relates to: a method for forming a resist underlayer film; and a patterning process.

### BACKGROUND ART

Along with high integration and high processing speed of LSI, miniaturization of pattern size is rapidly advancing. Along with the miniaturization, lithography technology has achieved a fine patterning by shortening wavelength of a light source and selecting an appropriate resist composition accordingly. The composition mainly used is a positive photoresist composition for monolayer. The monolayer positive photoresist composition not only allows a resist resin to have a skeleton having etching resistance against dry etching with chlorine- or fluorine-based gas plasma, but also provides a switching mechanism that makes an exposed part soluble, thereby dissolving the exposed part to form a pattern and processing a substrate to be processed by dry etching while using the remaining resist pattern as an etching mask.

However, when the pattern becomes finer, that is, the pattern width is reduced without changing the thickness of the photoresist film to be used, resolution performance of the photoresist film is lowered. In addition, pattern development of the photoresist film with a developer excessively increases a so-called aspect ratio of the pattern, resulting in pattern collapse. Therefore, the photoresist film has been thinned along with the miniaturization of the pattern.

On the other hand, a substrate to be processed has been generally processed by dry etching while using a pattern-formed photoresist film as an etching mask. In practice, however, there is no dry etching method capable of providing an absolute etching selectivity between the photoresist film and the substrate to be processed. The photoresist film is thus also damaged and collapses during processing of the substrate, and the resist pattern cannot be accurately transferred to the substrate to be processed. Accordingly, higher dry etching resistance has been required in a resist composition along with the miniaturization of the pattern. However, on the other hand, a resin used for the photoresist composition needs to have low light absorption at exposure wavelength in order to improve the resolution. For this reason, the resin has shifted to a novolak resin, polyhydroxystyrene, and a resin having an aliphatic polycyclic skeleton as the exposure light shifted from i-line to KrF and ArF, which have shorter wavelength. However, this shift has actually accelerated an etching rate under dry etching conditions for processing the substrate, and recent photoresist compositions having high resolution rather tend to have low etching resistance.

As a result, the substrate to be processed has to be dry-etched with a thinner photoresist film having lower etching resistance. Therefore, a demand for finding a composition used in this processing and the process therefor has become urgent.

A multilayer resist method is one of the solutions for the above problems. This method is as follows: a resist underlayer film having a different etching selectivity from a photoresist film (i.e., a resist upper layer film) is placed between the resist upper layer film and a substrate to be processed; a pattern is formed in the resist upper layer film; the pattern is transferred to the resist underlayer film by dry etching while using the resist upper layer film pattern as a dry etching mask; and the pattern is further transferred to the substrate to be processed by dry etching while using the resist underlayer film as a dry etching mask.

One of the multilayer resist methods is a three-layer resist method, which can be performed with a typical resist composition used in the monolayer resist method. For example, this three-layer resist method includes the following steps: an organic film containing a novolak resin or the like is formed as a resist underlayer film on a substrate to be processed; a silicon-containing resist middle layer film is formed thereon as a resist middle layer film; and a usual organic photoresist film is formed thereon as a resist upper layer film. Since the organic resist upper layer film ensures an excellent etching selectivity ratio relative to the silicon-containing resist middle layer film when dry etching is performed with fluorine-based gas plasma, the resist upper layer film pattern can be transferred to the silicon-containing resist middle layer film by dry etching with fluorine-based gas plasma. This method allows the pattern to be transferred to the silicon-containing resist middle layer film (resist middle layer film) even by using a resist composition with which it is difficult to form a pattern having a sufficient film thickness for directly processing the substrate to be processed or a resist composition that has insufficient dry etching resistance for processing the substrate. Then, further performing dry etching with oxygen gas plasma or hydrogen gas plasma allows the pattern to be transferred to the organic film (resist underlayer film) containing a novolak resin or the like, which has a sufficient dry etching resistance for processing the substrate. As to the resist underlayer film, many materials are already known as disclosed in Patent Document 1, for example.

On the other hand, in recent years, with the rapid miniaturization of DRAM memory, there is a growing need for further improvement in dry etching resistance, as well as a need for a resist underlayer film having excellent filling and planarizing properties. As a coating-type resist underlayer film composition excellent in filling and planarizing properties, for example, the composition disclosed in Patent Document 2 has been reported. In addition, it has been reported in Patent Document 3 that the dry etching resistance of a resist underlayer film composition can be improved by a heat treatment under an atmosphere having an oxygen concentration of 1% by volume or less at a temperature of 450 to 800°C. However, in view of application of this composition in the advanced generation, there is a concern about the dry etching resistance of resist underlayer film compositions. The application limit of the previously-known coating-type resist underlayer film composition is thus approaching.

To solve the problems, there is consideration of development of the use of a material containing a metal element for a resist underlayer film. Patent Document 4 reports that a material containing a Ti compound exhibits excellent dry etching resistance to CHF₃/CF₄-based gas and CO₂/N₂-based gas.

On the other hand, filling property is a problem when using a metal compound for a resist underlayer film. Although there is no mention of filling property in Patent Document 4, a metal compound generally undergoes great thermal shrinkage during baking and induces remarkable degradation of filling after baking at a high temperature. Therefore, there is a concern that such a compound is insufficient as a resist underlayer film material for which high planarizing and filling properties and heat resistance are required.

Patent Documents 5 and 6 report that a metal compound modified with a particular ligand has excellent filling property. However, the baking temperature in the performed filling property evaluation is a low temperature of 150°C, and there is a concern that the compound is insufficient as a resist underlayer film, which requires heat resistance (for example, resistance to a heat treatment that is performed after the formation of a resist underlayer film in some cases).

### CITATION LIST

### PATENT LITERATURE

Patent Document 1: JP2004-205685A
Patent Document 2: JP6714493B2
Patent Document 3: JP6711104B2
Patent Document 4: JP6189758B2
Patent Document 5: JP6786391B2
Patent Document 6: JP7050137B2

### SUMMARY OF INVENTION

### TECHNICAL PROBLEM

The present invention has been made in view of the above-described circumstances. An object of the present invention is to provide: a method for forming a resist underlayer film that contains metal and that exhibits both high filling property and high dry etching resistance; and a patterning process using the method.

### SOLUTION TO PROBLEM

To achieve the object, the present invention provides a method for forming a resist underlayer film, comprising:
a coating step of coating a substrate with a composition for forming a resist underlayer film containing a metal compound having a metal-oxygen covalent bond and an organic solvent; and
a heating step of heating the coated substrate in an atmosphere having an oxygen concentration of less than 1 volume % at a temperature of 450°C or higher and 800°C or lower, wherein
a compound containing at least one crosslinking group represented by the following general formulae (a-1) to (a-4), (b-1) to (b-4), and (c-1) to (c-3) is used as the metal compound, 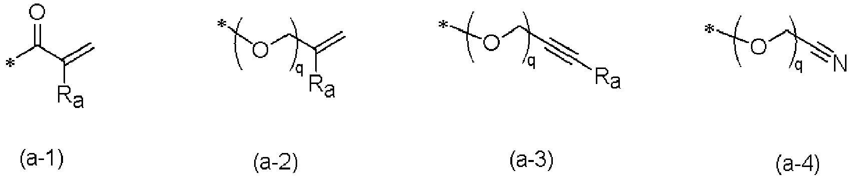 wherein Rₐ represents a hydrogen atom or a monovalent organic group having 1 to 10 carbon atoms, "q" represents 0 or 1, and "*" represents an attachment point, 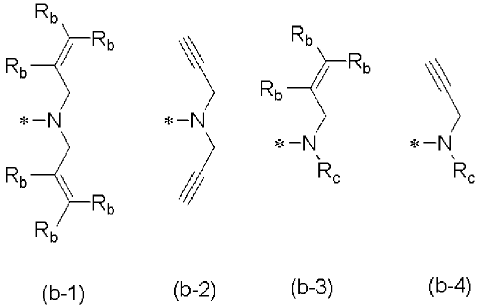 wherein R_{b}s represent a hydrogen atom or a methyl group and are identical to or different from each other in a single formula, R_{c} represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms, and "*" represents an attachment point, 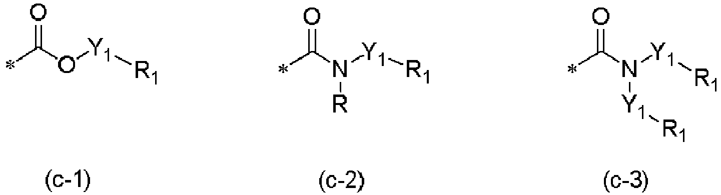 wherein Y₁ represents a divalent organic group having 1 to 20 carbon atoms, R represents a hydrogen atom, a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms, R₁ represents an organic group whose protecting group is to be removed by an action of an acid, heat, or both to generate one or more hydroxy groups or carboxy groups, R₁ being represented by one of the following general formulae (1), and "*" represents an attachment point, 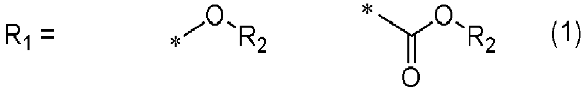 wherein R₂ represents an organic group whose protecting group is to be removed by an action of an acid, heat, or both, and "*" represents an attachment point to Y₁.

Such a method for forming a resist underlayer film can greatly improve the dry etching resistance of a metal-containing material having excellent filling property, and makes it possible to form a resist underlayer film that contains a metal and that can achieve both high filling property and high dry etching resistance, which are difficult to achieve by conventional techniques.

In the present invention, the oxygen concentration is preferably set to 0.1 volume % or less.

By setting the oxygen concentration as described, dry etching resistance can be enhanced without degradation of the filling property of the resist underlayer film.

In the present invention, the temperature is preferably set to 500°C or higher and 600°C or lower.

By performing the heating at such a temperature, dry etching resistance can be enhanced without degradation of the filling property of the resist underlayer film.

In the present invention, the metal contained in the metal compound is preferably titanium, zirconium, hafnium, or a combination thereof.

When a metal mentioned above is contained, the dry etching resistance at the time of substrate processing can be improved further.

In the present invention, a compound containing a ligand derived from a silicon compound represented by the following general formula (2) is preferably further used as the metal compound, 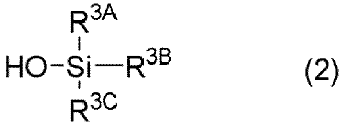 wherein R^{3A}, R^{3B}, and R^{3C} each represent any organic group selected from an organic group having 2 to 30 carbon atoms and having any crosslinking group of a structure represented by the following general formulae (d-1) to (d-3), a substituted or unsubstituted alkyl group having 1 to 20 carbon atoms, and an aryl group having 6 to 20 carbon atoms, 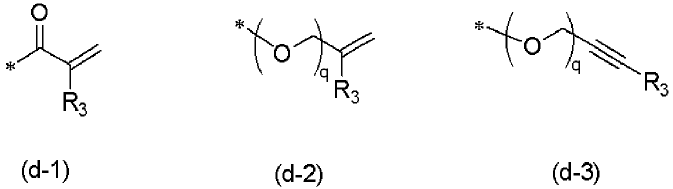 wherein R₃ represents a hydrogen atom or a monovalent organic group having 1 to 10 carbon atoms, "q" represents 0 or 1, and "*" represents an attachment point.

According to the method for forming a resist underlayer film, using the metal compound containing the silicon-containing compound, it is possible to form a resist underlayer film having better filling property.

The present invention also provides a patterning process for forming a pattern in a substrate to be processed, comprising the steps of:
(I-1) forming a resist underlayer film on a substrate to be processed by the above-described method for forming a resist underlayer film;
(I-2) forming a silicon-containing resist middle layer film on the resist underlayer film;
(I-3) forming a resist upper layer film on the silicon-containing resist middle layer film by using a photoresist material;
(I-4) subjecting the resist upper layer film to pattern exposure and then development with a developer to form a pattern in the resist upper layer film;
(I-5) transferring the pattern to the silicon-containing resist middle layer film by dry etching while using the resist upper layer film having the formed pattern as a mask;
(I-6) transferring the pattern to the resist underlayer film by dry etching while using the silicon-containing resist middle layer film having the transferred pattern as a mask; and
(1-7) processing the substrate to be processed while using the resist underlayer film having the formed pattern as a mask to form the pattern in the substrate to be processed.

The patterning process makes it possible to form fine patterns on the body to be processed with high precision.

The present invention also provides a patterning process for forming a pattern in a substrate to be processed, comprising the steps of:
(II-1) forming a resist underlayer film on a substrate to be processed by the above-described method for forming a resist underlayer film;
(II-2) forming an inorganic hard mask middle layer film selected from the group consisting of a silicon oxide film, a silicon nitride film, and a silicon oxynitride film on the resist underlayer film;
(II-3) forming an organic thin film on the inorganic hard mask middle layer film;
(II-4) forming a resist upper layer film on the organic thin film by using a photoresist material;
(II-5) subjecting the resist upper layer film to pattern exposure and then development with a developer to form a pattern in the resist upper layer film;
(II-6) transferring the pattern to the organic thin film and the inorganic hard mask middle layer film by dry etching while using the resist upper layer film having the formed pattern as a mask;
(II-7) transferring the pattern to the resist underlayer film by dry etching while using the inorganic hard mask middle layer film having the transferred pattern as a mask; and
(II-8) processing the substrate to be processed while using the resist underlayer film having the formed pattern as a mask to form the pattern in the substrate to be processed.

The patterning process makes it possible to form fine patterns on the body to be processed with a high degree of accuracy.

The present invention also provides a patterning process for forming a pattern in a substrate to be processed, comprising the steps of:
(III-1) forming a resist underlayer film on a substrate to be processed by the above-described method for forming a resist underlayer film;
(III-2) forming an organic middle layer film on the resist underlayer film;
(III-3) forming a silicon-containing resist middle layer film or a combination of an inorganic hard mask middle layer film selected from the group consisting of a silicon oxide film, a silicon nitride film, and a silicon oxynitride film and an organic thin film on the organic middle layer film;
(III-4) forming a resist upper layer film on the silicon-containing resist middle layer film or the organic thin film by using a photoresist material;
(III-5) subjecting the resist upper layer film to pattern exposure and then development with a developer to form a pattern in the resist upper layer film;
(III-6) transferring the pattern to the silicon-containing resist middle layer film or the organic thin film and the inorganic hard mask middle layer film by dry etching while using the resist upper layer film having the formed pattern as a mask;
(III-7) transferring the pattern to the organic middle layer film by dry etching while using the silicon-containing resist middle layer film or the inorganic hard mask middle layer film having the transferred pattern as a mask;
(III-8) transferring the pattern to the resist underlayer film by dry etching while using the organic middle layer film having the transferred pattern as a mask; and
(III-9) processing the substrate to be processed while using the resist underlayer film having the formed pattern as a mask to form the pattern in the substrate to be processed.

The patterning process makes it possible to form fine patterns on the body to be processed with a high degree of accuracy.

The present invention also provides a method for forming a resist underlayer film, comprising:
a coating step of coating a substrate with a composition for forming a resist underlayer film containing a metal belonging to the third period to the seventh period and the group III to the group XV of the periodic table; and
a heating step of heating the coated substrate in an atmosphere having an oxygen concentration of less than 1 volume % at a temperature of 450°C or higher and 800°C or lower.

Such a method for forming a resist underlayer film can greatly improve the dry etching resistance of a metal-containing material having excellent filling property, and makes it possible to form a resist underlayer film that contains a metal and that can achieve both high filling property and high dry etching resistance, which are difficult to achieve by conventional techniques.

In this event, a composition containing a metal compound having a metal-oxygen covalent bond or containing a metal compound having a metal-carbon covalent bond is preferably used as the composition for forming a resist underlayer film.

Such a method for forming a resist underlayer film makes it possible to form a resist underlayer film that can achieve both high filling property and high dry etching resistance, which are difficult to achieve by conventional techniques.

### ADVANTAGEOUS EFFECTS OF INVENTION

As described above, the inventive methods for forming a resist underlayer film and patterning processes are particularly suitably employed in multilayer resist processes that include the filling and planarization of a stepped or uneven substrate to be processed, and are extremely useful in fine patterning for manufacturing a semiconductor device. In particular, in a fine patterning process using a multilayer resist method in a semiconductor device manufacturing process, filling is possible without causing defects such as voids and peeling even on a substrate to be processed having a portion that is difficult to fill and planarize, such as a dense portion of a fine pattern structure having a high aspect ratio exemplified by increasingly miniaturized DRAM. Thus, a resist underlayer film having excellent planarizing property can be formed. Furthermore, better etching resistance can be exhibited compared to conventional methods for forming a resist underlayer film, and in particular, by the heating in an atmosphere having an oxygen concentration of less than 1 volume % at a temperature of 450°C or higher and 800°C or lower, the advantageous effects can be exhibited. Therefore, a fine pattern can be formed on a body to be processed with even higher precision.

### BRIEF DESCRIPTION OF DRAWINGS

FIG. 1 is an explanatory view of an example (three-layer resist process) of the patterning process of the present invention.
FIG. 2 is an explanatory view of a method for evaluating the filling property.

### DESCRIPTION OF EMBODIMENTS

As stated above, there have been demands for the development of: a method for forming a resist underlayer film that makes it possible to transfer a resist pattern to a substrate to be processed with higher precision in a fine patterning process according to a multilayer resist method; and a patterning process using the method for forming a resist underlayer film.

Generally, metal oxide compounds undergo great thermal shrinkage during baking, and this induces considerable degradation in filling property after high-temperature baking. Patent Document 5, which, therefore, causes concerns of being inadequate for resist underlayer film materials, which are required to have high planarizing and filling properties and heat resistance, reports a metal-containing material excellent in filling property. However, since the material contains many organic components, it is thought that dry etching resistance at the time of substrate processing, which is a strength of metal materials, is insufficient. The filling property and dry etching resistance of a metal material are in a trade-off relationship, and a breakthrough has been necessary. The present inventors have hypothesized that by promoting the dissociation and rebonding of carbon bonds contained in a metal-containing film whose steps have been filled, it may be possible to improve dry etching resistance without the filling property being degraded, and studied earnestly. As a result, the present inventors have found out that, according to a method for forming a resist underlayer film including heating a metal-containing resist underlayer film in an atmosphere having an oxygen concentration of less than 1 volume % at a temperature of 450°C or higher and 800°C or lower, it is possible to improve greatly the dry etching resistance at the time of substrate processing without the filling property of the resist underlayer film being degraded. Thus, the present invention has been completed.

That is, the present invention is a method for forming a resist underlayer film, comprising:
a coating step of coating a substrate with a composition for forming a resist underlayer film containing a metal compound having a metal-oxygen covalent bond and an organic solvent; and
a heating step of heating the coated substrate in an atmosphere having an oxygen concentration of less than 1 volume % at a temperature of 450°C or higher and 800°C or lower, wherein
a compound containing at least one crosslinking group represented by the following general formulae (a-1) to (a-4), (b-1) to (b-4), and (c-1) to (c-3) is used as the metal compound, 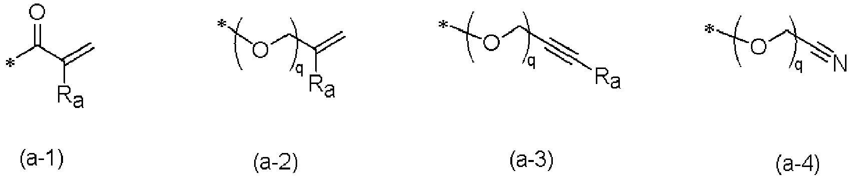 wherein Rₐ represents a hydrogen atom or a monovalent organic group having 1 to 10 carbon atoms, "q" represents 0 or 1, and "*" represents an attachment point, 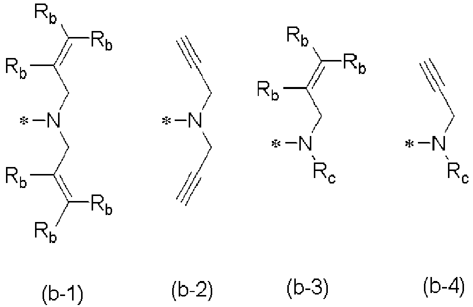 wherein R_{b}s represent a hydrogen atom or a methyl group and are identical to or different from each other in a single formula, R_{c} represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms, and "*" represents an attachment point, 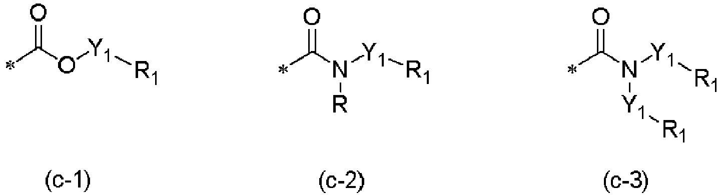 wherein Y₁ represents a divalent organic group having 1 to 20 carbon atoms, R represents a hydrogen atom, a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms, R₁ represents an organic group whose protecting group is to be removed by an action of an acid, heat, or both to generate one or more hydroxy groups or carboxy groups, R₁ being represented by one of the following general formulae (1), and "*" represents an attachment point, 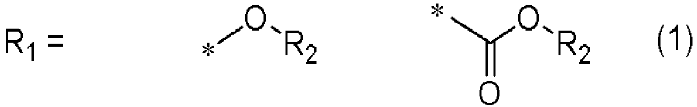 wherein R₂ represents an organic group whose protecting group is to be removed by an action of an acid, heat, or both, and "*" represents an attachment point to Y₁.

In addition, the present invention is a method for forming a resist underlayer film, comprising:
a coating step of coating a substrate with a composition for forming a resist underlayer film containing a metal belonging to the third period to the seventh period and the group III to the group XV of the periodic table; and
a heating step of heating the coated substrate in an atmosphere having an oxygen concentration of less than 1 volume % at a temperature of 450°C or higher and 800°C or lower.

Hereinafter, the present invention will be described in detail, but the present invention is not limited thereto.

### <Method for Forming Resist Underlayer Film>

The present invention is a method for forming a resist underlayer film, including:
a coating step of coating a substrate with a composition for forming a resist underlayer film containing a metal belonging to the third period to the seventh period and the group III to the group XV of the periodic table; and
a heating step of heating the coated substrate in an atmosphere having an oxygen concentration of less than 1 volume % at a temperature of 450°C or higher and 800°C or lower.

According to such a method for forming a resist underlayer film, it is possible to form a resist underlayer film excellent in etching resistance during substrate processing without degrading filling property.

In this event, a composition containing a metal compound having a metal-oxygen covalent bond or containing a metal compound having a metal-carbon covalent bond is preferably used as the composition for forming a resist underlayer film.

According to such a method for forming a resist underlayer film, it is possible to form a resist underlayer film that can achieve both high filling property and high dry etching resistance, which are difficult to achieve by conventional techniques.

In addition, the present invention is a method for forming a resist underlayer film, including:
a coating step of coating a substrate with a composition for forming a resist underlayer film containing a metal compound having a metal-oxygen covalent bond and an organic solvent; and
a heating step of heating the coated substrate in an atmosphere having an oxygen concentration of less than 1 volume % at a temperature of 450°C or higher and 800°C or lower, where
a compound containing at least one crosslinking group represented by the following general formulae (a-1) to (a-4), (b-1) to (b-4), and (c-1) to (c-3) is used as the metal compound.

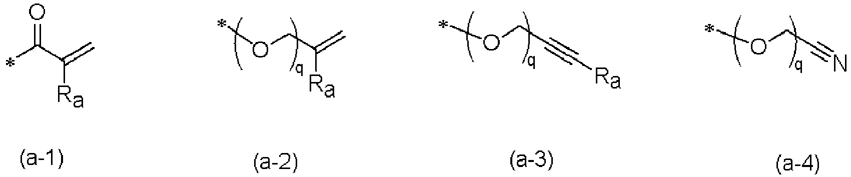

In the general formulae (a-1) to (a-4), Rₐ represents a hydrogen atom or a monovalent organic group having 1 to 10 carbon atoms, "q" represents 0 or 1, and "*" represents an attachment point.

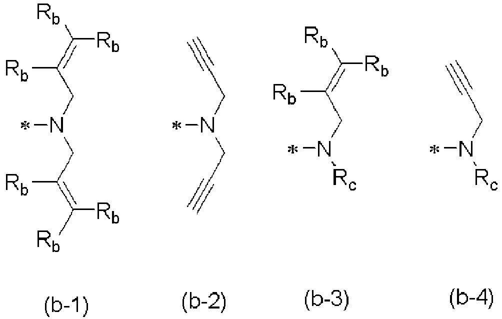

In the general formulae (b-1) to (b-4), R_{b}s represent a hydrogen atom or a methyl group and are identical to or different from each other in a single formula, R_{c} represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms, and "*" represents an attachment point.

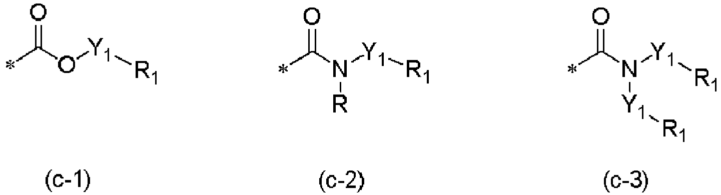

In the general formulae (c-1) to (c-3), Y₁ represents a divalent organic group having 1 to 20 carbon atoms, R represents a hydrogen atom, a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms, R₁ represents an organic group whose protecting group is to be removed by an action of an acid, heat, or both to generate one or more hydroxy groups or carboxy groups, R₁ being represented by one of the following general formulae (1), and "*" represents an attachment point.

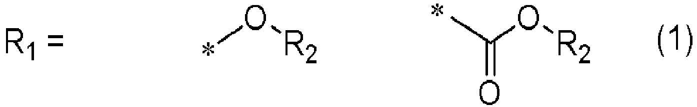

In the general formulae (1), R₂ represents an organic group whose protecting group is to be removed by an action of an acid, heat, or both, and "*" represents an attachment point to Y₁.

According to such a method for forming a resist underlayer film, it is possible to form a resist underlayer film excellent in etching resistance during substrate processing without degrading filling property.

During the heating, the oxygen concentration in the atmosphere is less than 1 volume %, preferably 0.1 volume % or less, more preferably 0.01 volume % or less, and further preferably 0.005 volume % or less.

By performing the heat treatment with the above-described oxygen concentration, rapid volume shrinkage of the resist underlayer film can be suppressed, and organic components in the resist underlayer film can be removed mildly. Therefore, dry etching resistance can be improved without degrading filling property. Moreover, even in a case where the substrate to be processed easily undergoes air oxidation, damage to the substrate can be suppressed by forming the resist underlayer film by heat-treating in an atmosphere having an oxygen concentration of less than 1 volume %.

The temperature at which to bake the resist underlayer film is 450°C or higher and 800°C or lower, preferably 450°C or higher and 650°C or lower, further preferably 500°C or higher and 600°C or lower. The baking time is preferably in the range of 10 seconds to 7,200 seconds, further preferably 30 seconds to 600 seconds.

By adjusting the baking temperature and time appropriately within the above-described ranges, it is possible to achieve the planarizing and filling properties and curing properties, such as dry etching resistance and heat resistance, suitable for the intended usage. By performing the baking within the temperature range of 450°C or higher to 800°C or lower, organic components in the resist underlayer film are decomposed and modification to a metal oxide film is facilitated, and therefore, a resist underlayer film excellent in dry etching resistance can be formed. If the baking temperature is lower than 450°C, the organic components in the film cannot be reduced. If the baking temperature exceeds 800°C, crystallization of the metal-containing film cannot be suppressed. The heating can also be performed in a plurality of steps (step baking).

### <Composition for Forming Resist Underlayer Film>

The composition for forming a resist underlayer film used in the inventive method for forming a resist underlayer film contains a metal belonging to the third period to the seventh period and the group III to the group XV of the periodic table.

Examples of metals belonging to the third period to the seventh period and the group III to the group XV of the periodic table include:
as metals of the group III, scandium, yttrium, lanthanum, cerium, etc.;
as metals of the group IV, titanium, zirconium, hafnium, etc.;
as metals of the group V, vanadium, niobium, tantalum, etc.;
as metals of the group VI, chromium, molybdenum, tungsten, etc.;
as metals of the group VII, manganese, rhenium, etc.;
as metals of the group VIII, iron, ruthenium, osmium, etc.;
as metals of the group IX, cobalt, rhodium, iridium, etc.;
as metals of the group X, nickel, palladium, platinum, etc.;
as metals of the group XI, copper, silver, gold, etc.;
as metals of the group XII, zinc, cadmium, mercury, etc.;
as metals of the group XIII, aluminum, gallium, indium, etc.;
as metals of the group XIV, germanium, tin, lead, etc.; and
as metals of the group XV, antimony, bismuth, etc.

The metals of the group IV to the group VI and the group XIII to the group XV are more preferable, and titanium, zirconium, and hafnium are further preferable.

Such a composition for forming a resist underlayer film can provide a resist underlayer film that exhibits outstanding dry etching resistance. According to the inventive method for forming a resist underlayer film, the dry etching resistance can be enhanced without degrading the filling property of the resist underlayer film.

In this event, as the composition for forming a resist underlayer film, it is preferable to use a composition containing a metal compound having a metal-oxygen covalent bond or containing a metal compound having a metal-carbon covalent bond.

According to such a method for forming a resist underlayer film, it is possible to form a resist underlayer film that can achieve both high filling property and high dry etching resistance, which are difficult to achieve by conventional techniques.

In addition, the composition for forming a resist underlayer film to be used in the inventive method for forming a resist underlayer film contains (A) a metal compound and (B) an organic solvent.

Such a composition for forming a resist underlayer film contains a metal compound that has both high thermal flowability and high thermosetting property, and therefore, exhibits high filling and planarizing properties, and can provide a resist underlayer film that exhibits outstanding dry etching resistance by being subjected to a high-temperature baking treatment. Since a resist underlayer film excellent in heat resistance can be formed, dry etching resistance can be improved without filling property being degraded due to the high-temperature baking treatment.

### [(A) Metal Compound]

The metal compound contained in the composition for forming a resist underlayer film used in the inventive method for forming a resist underlayer film has a metal-oxygen covalent bond and contains at least one crosslinking group represented by the following general formulae (a-1) to (a-4), (b-1) to (b-4), and (c-1) to (c-3) .

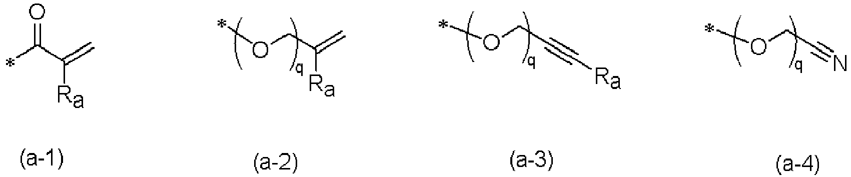

In the general formulae (a-1) to (a-4), Rₐ represents a hydrogen atom or a monovalent organic group having 1 to 10 carbon atoms, "q" represents 0 or 1, and "*" represents an attachment point.

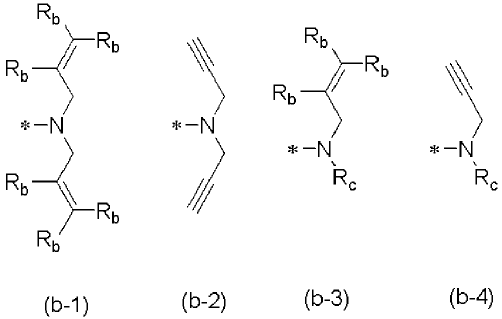

In the general formulae (b-1) to (b-4), R_{b}s represent a hydrogen atom or a methyl group and are identical to or different from each other in a single formula, R_{c} represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms, and "*" represents an attachment point.

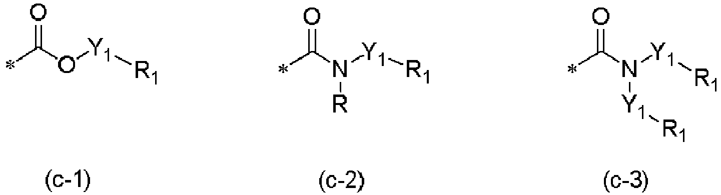

In the general formulae (c-1) to (c-3), Y₁ represents a divalent organic group having 1 to 20 carbon atoms, R represents a hydrogen atom, a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms, R₁ represents an organic group whose protecting group is to be removed by an action of an acid, heat, or both to generate one or more hydroxy groups or carboxy groups, R₁ being represented by one of the following general formulae (1), and "*" represents an attachment point.

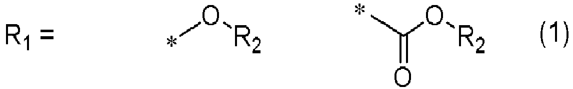

In the general formulae (1), R₂ represents an organic group whose protecting group is to be removed by an action of an acid, heat, or both, and "*" represents an attachment point to Y₁.

By the metal compound having a metal-oxygen covalent bond, high etching resistance can be achieved.

By the metal compound containing at least one crosslinking group represented by the general formulae (a-1) to (a-4), (b-1) to (b-4), and (c-1) to (c-3), a resist underlayer film having excellent filling property can be formed. Moreover, since a resist underlayer film excellent in heat resistance can be formed, dry etching resistance can be improved by carrying out baking within the temperature range of 450°C or higher to 800°C or lower without degrading the filling property.

Ligands coordinated to the metal compound are not particularly limited as long as one or more ligands having a crosslinking group represented by the general formulae (a-1) to (a-4), (b-1) to (b-4), and (c-1) to (c-3) are coordinated, but from the viewpoint of stability, a carboxylate, acetyl acetate, polyhydric alcohol, etc. are preferable.

Specific examples of ligands containing a crosslinking group represented by the general formulae (a-1) to (a-4) include the following compounds, but are not limited thereto.

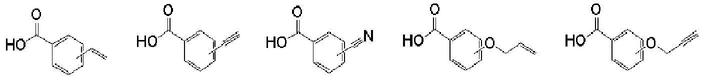

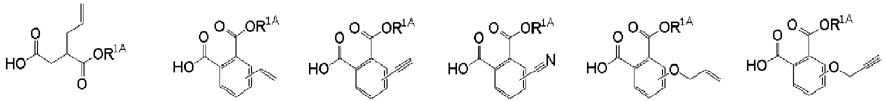

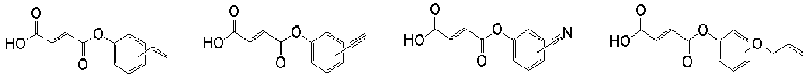

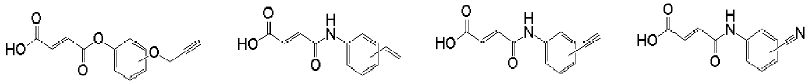

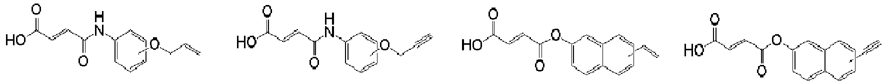

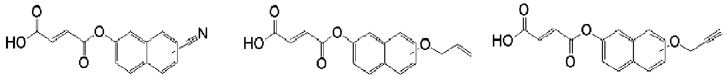

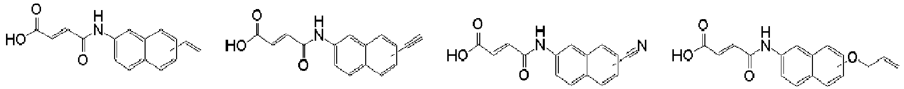

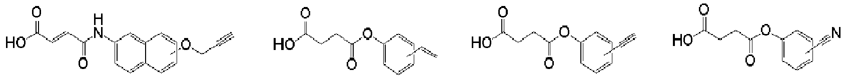

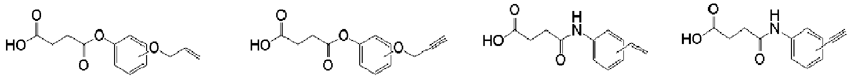

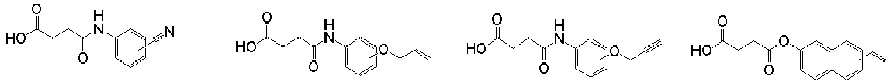

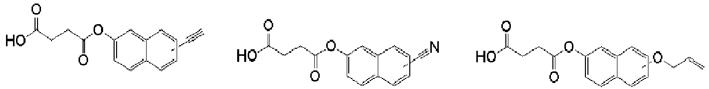

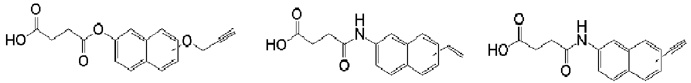

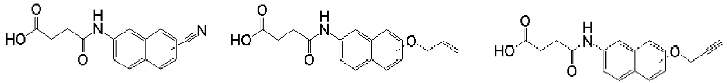

In the formulae, R^{1A} represents any organic group selected from a substituted or unsubstituted alkyl group having 1 to 20 carbon atoms and a substituted or unsubstituted aryl group having 6 to 20 carbon atoms.

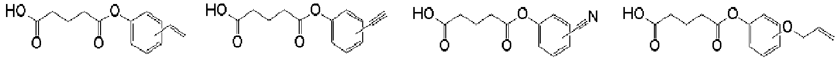

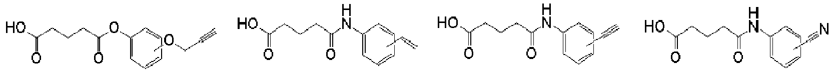

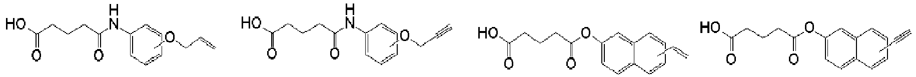

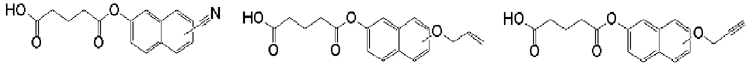

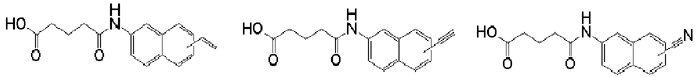

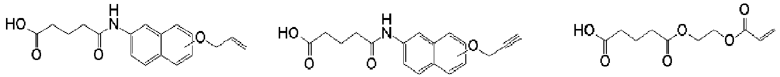

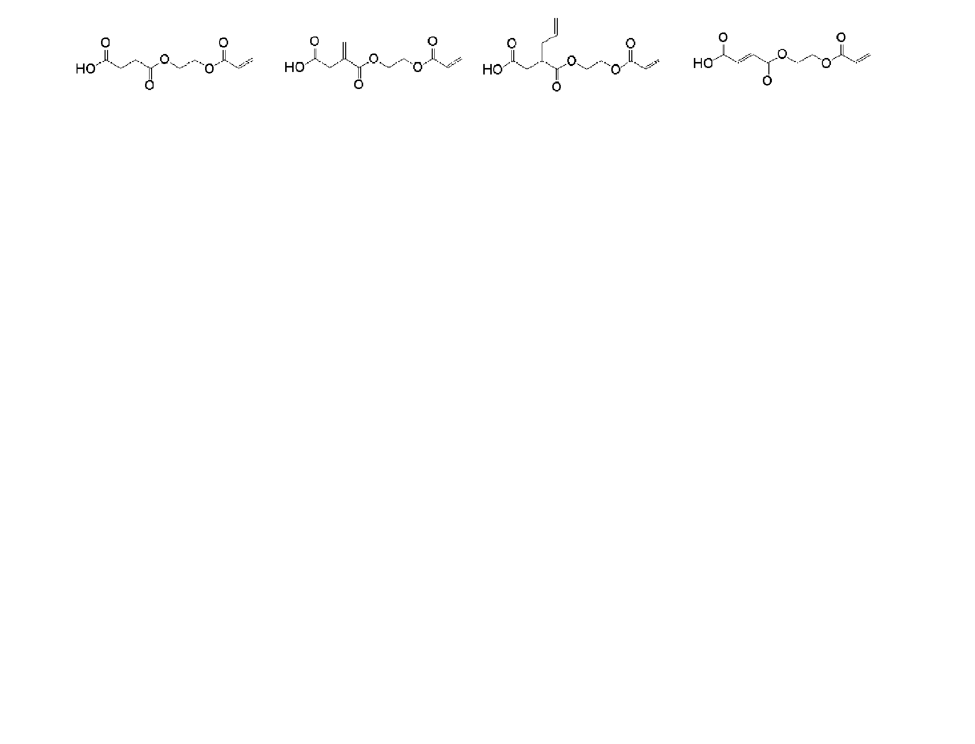

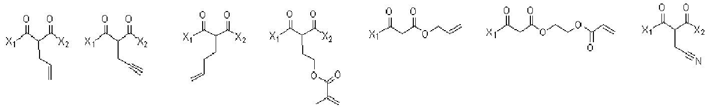

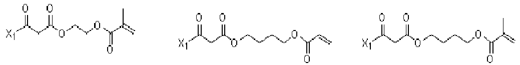

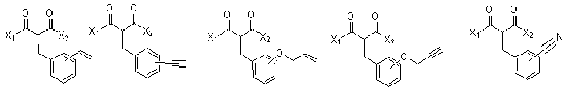

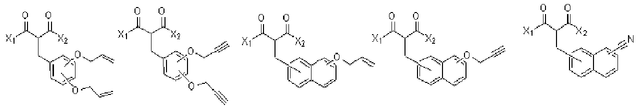

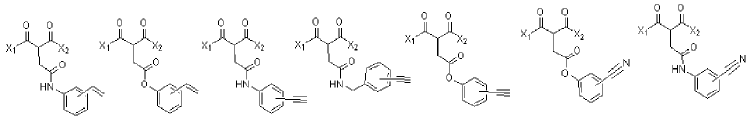

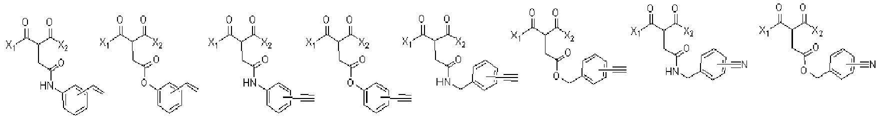

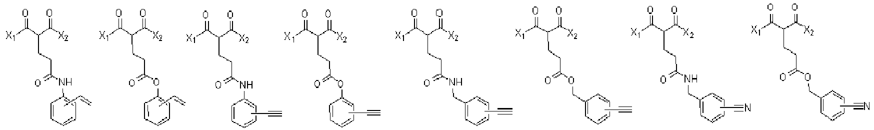

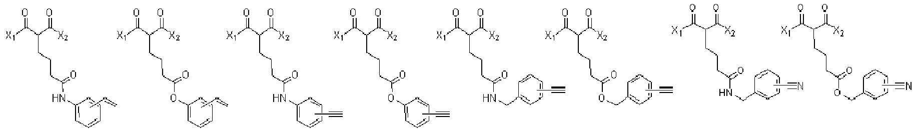

In the formulae, X₁ and X₂ each represent a hydrocarbon group having 1 to 20 carbon atoms or an alkoxy group having 1 to 20 carbon atoms.

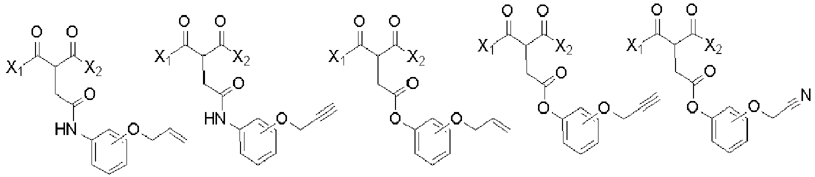

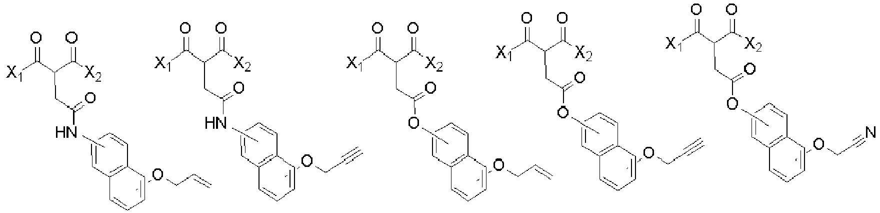

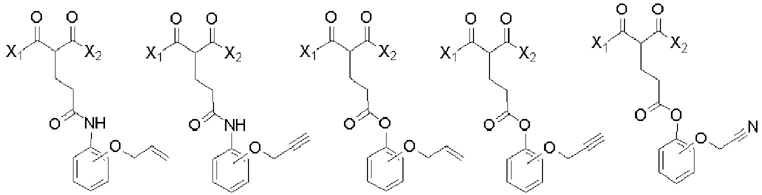

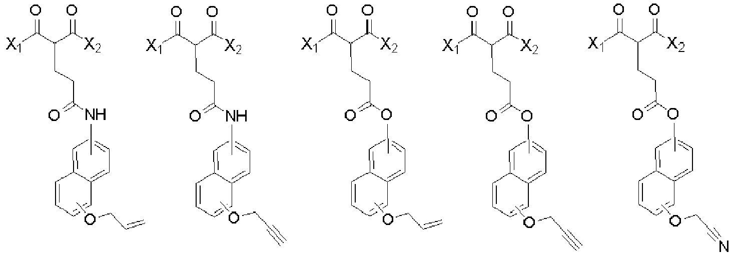

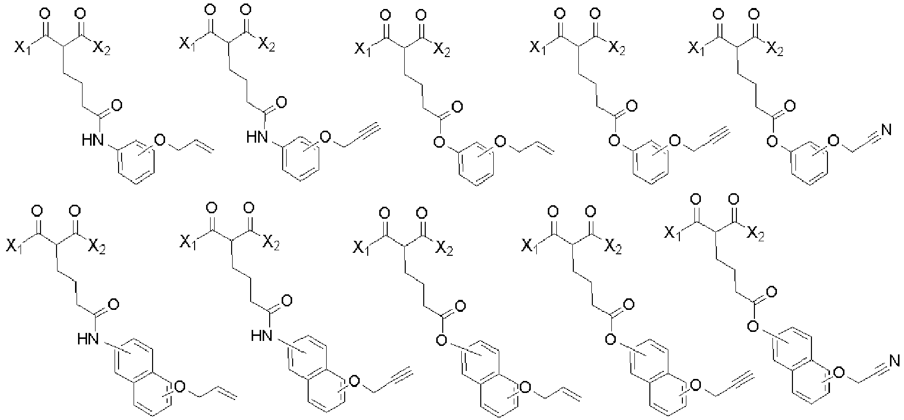

In the formulae, X₁ and X₂ each represent a hydrocarbon group having 1 to 20 carbon atoms or an alkoxy group having 1 to 20 carbon atoms.

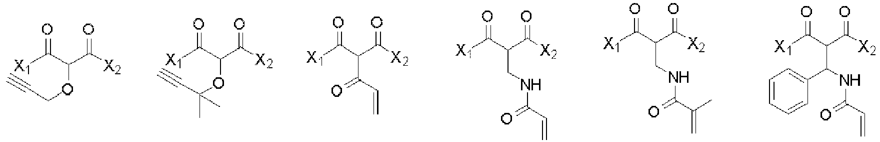

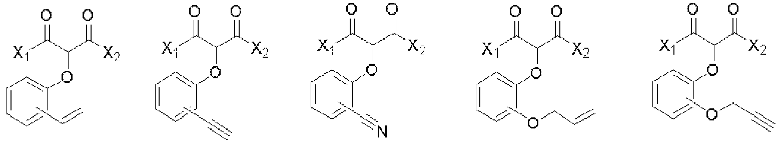

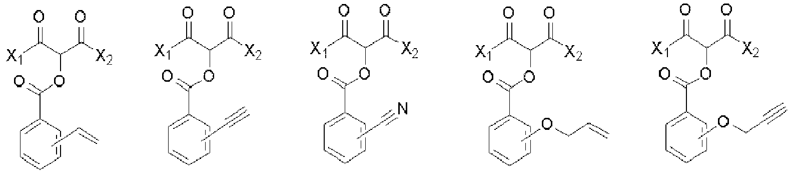

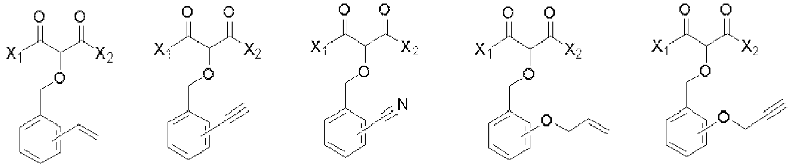

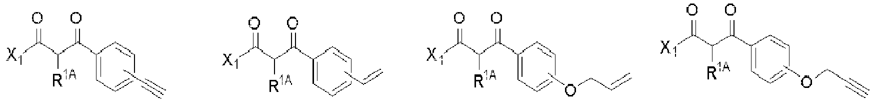

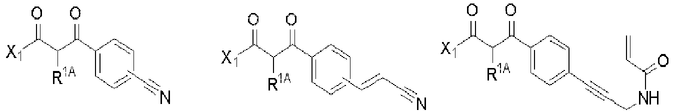

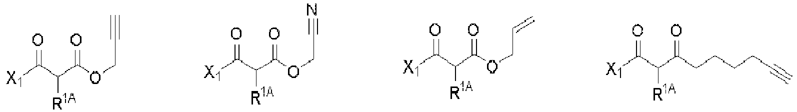

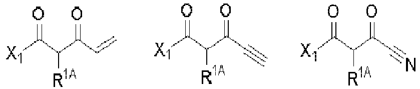

In the formulae, R^{1A} represents any organic group selected from a substituted or unsubstituted alkyl group having 1 to 20 carbon atoms and a substituted or unsubstituted aryl group having 6 to 20 carbon atoms; and X₁ and X₂ each represent a hydrocarbon group having 1 to 20 carbon atoms or an alkoxy group having 1 to 20 carbon atoms.

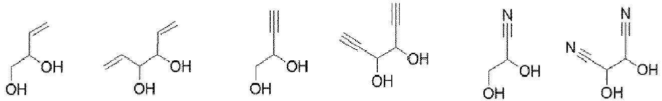

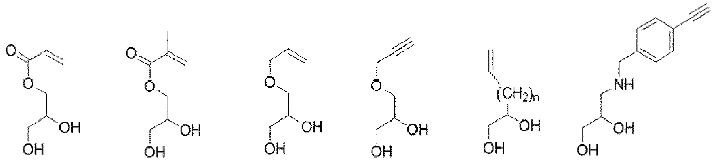

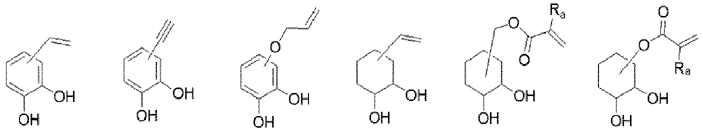

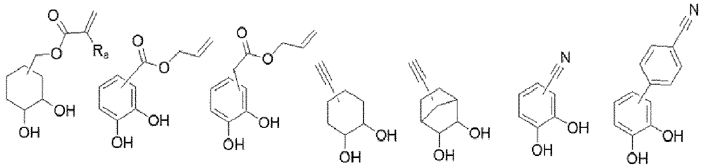

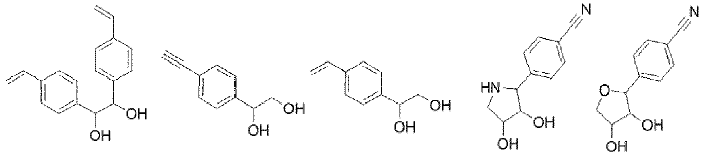

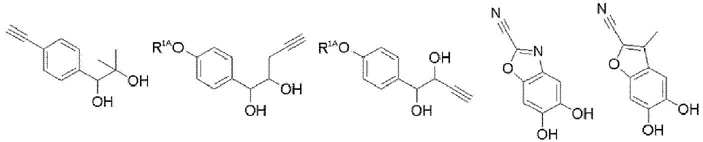

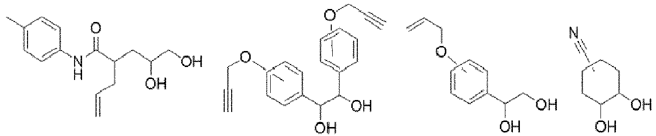

In the formulae, R^{1A} represents any organic group selected from a substituted or unsubstituted alkyl group having 1 to 20 carbon atoms and a substituted or unsubstituted aryl group having 6 to 20 carbon atoms; and Rₐ represents a hydrogen atom or a monovalent organic group having 1 to 10 carbon atoms.

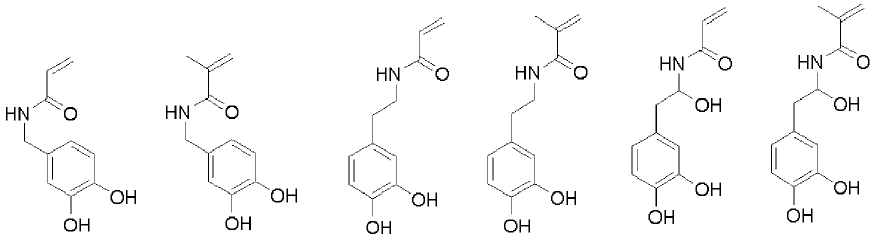

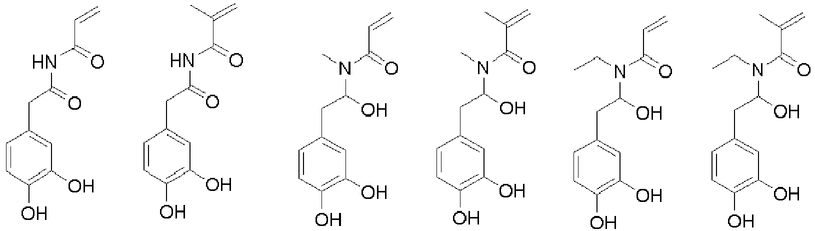

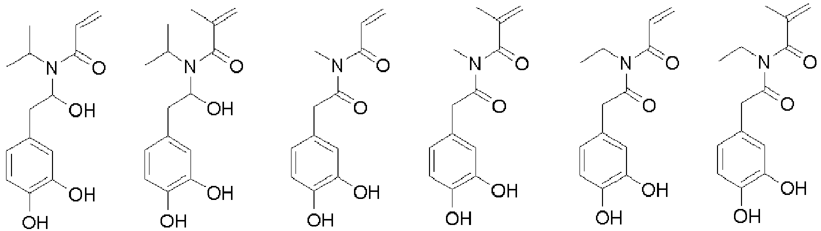

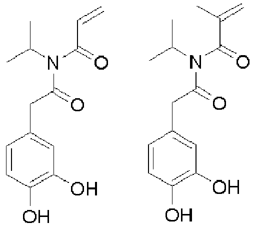

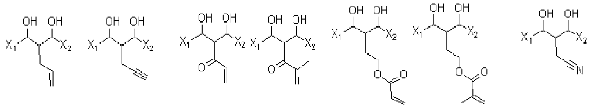

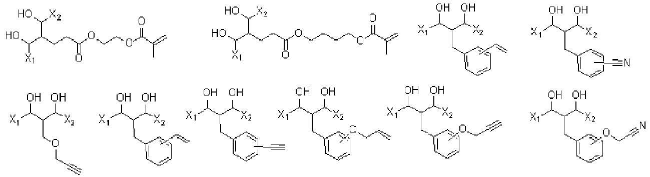

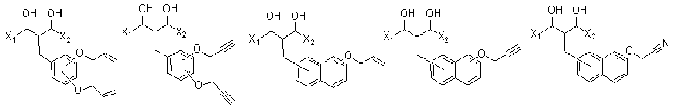

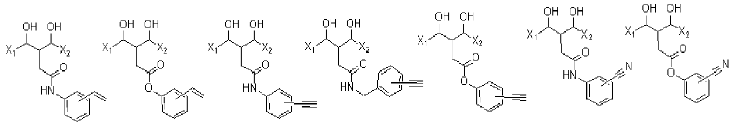

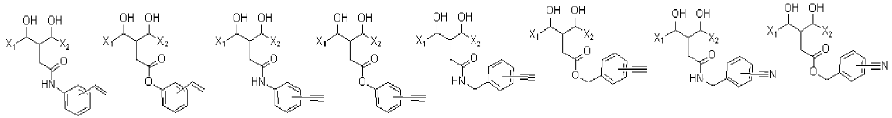

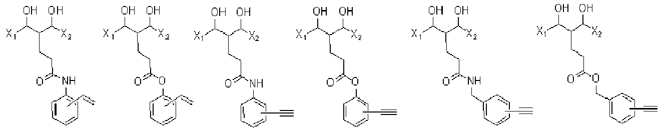

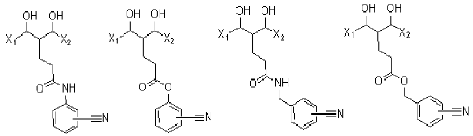

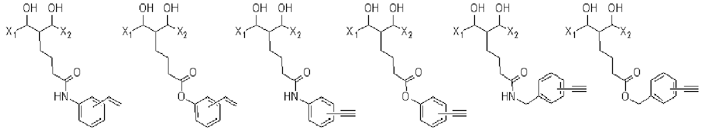

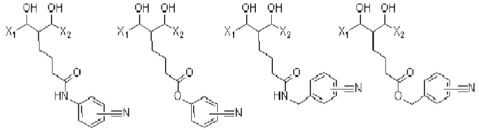

In the formulae, X₁ and X₂ each represent a hydrocarbon group having 1 to 20 carbon atoms or an alkoxy group having 1 to 20 carbon atoms.

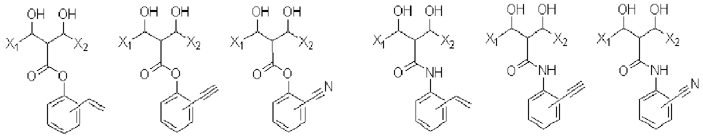

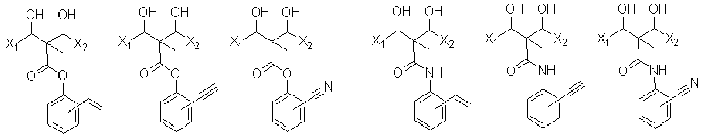

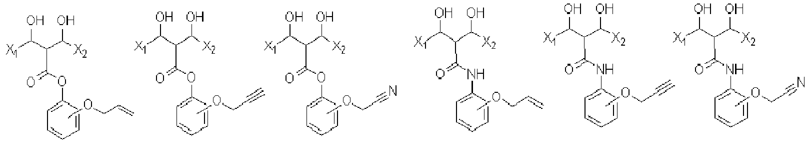

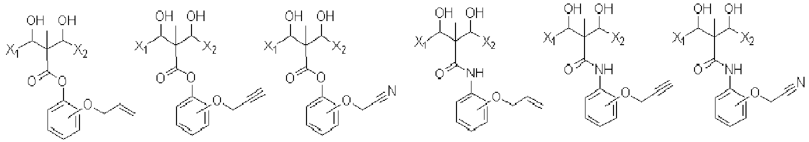

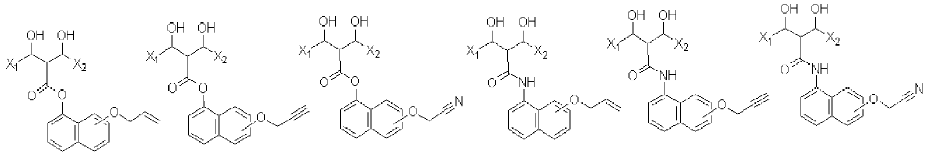

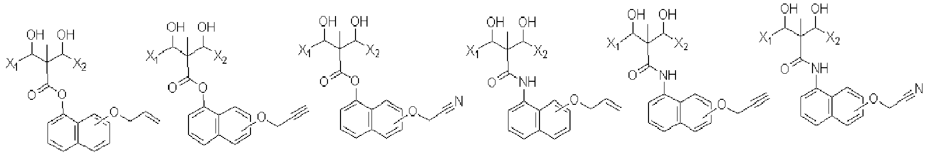

In the formulae, X₁ and X₂ each represent a hydrocarbon group having 1 to 20 carbon atoms or an alkoxy group having 1 to 20 carbon atoms.

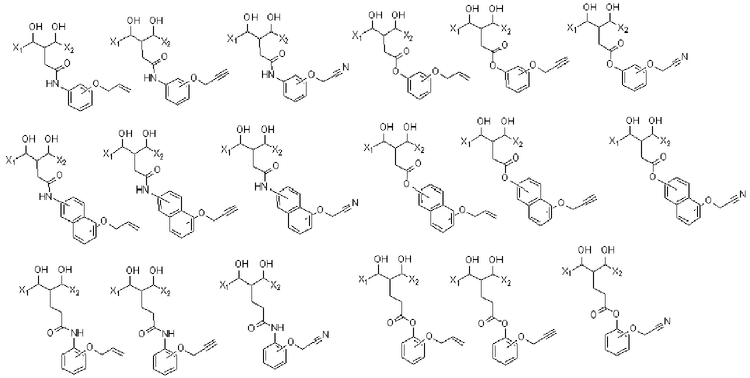

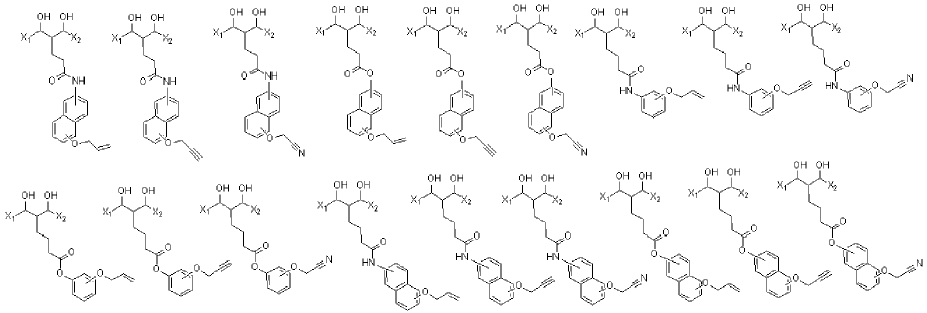

In the formulae, X₁ and X₂ each represent a hydrocarbon group having 1 to 20 carbon atoms or an alkoxy group having 1 to 20 carbon atoms.

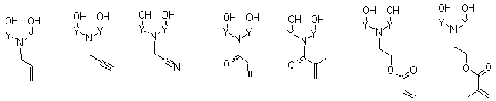

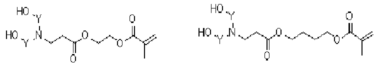

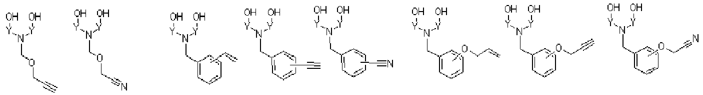

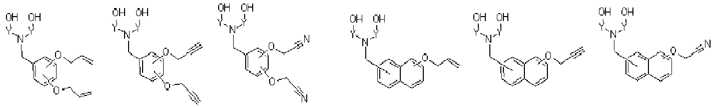

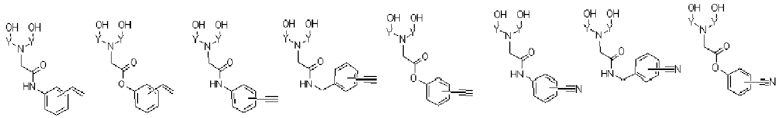

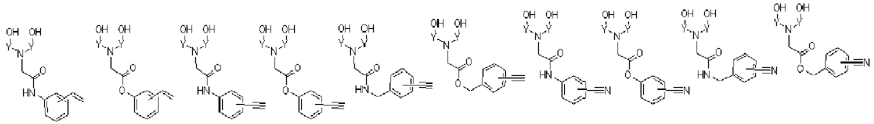

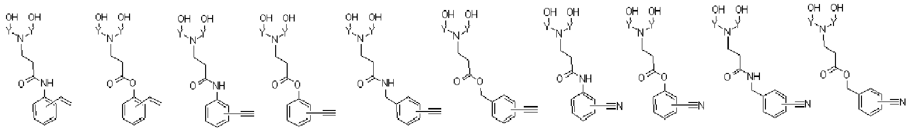

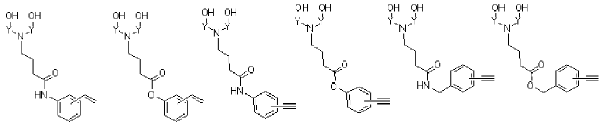

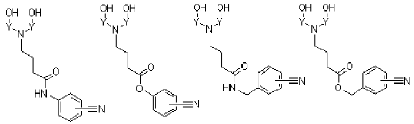

In the formulae, Y represents a divalent organic group having 1 to 10 carbon atoms.

Specific examples of ligands containing a crosslinking group represented by the general formulae (b-1) to (b-4) include the following compounds, but are not limited thereto.

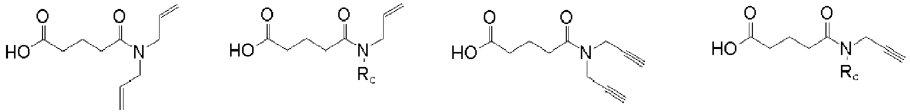

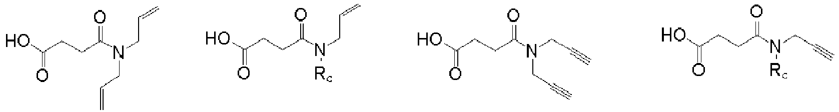

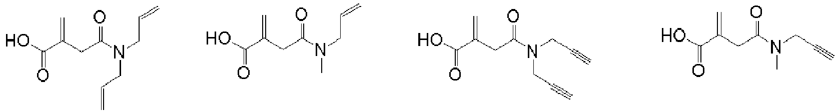

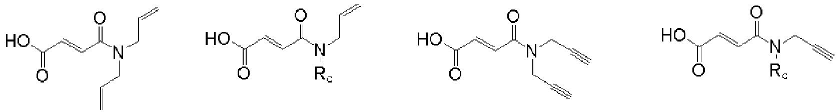

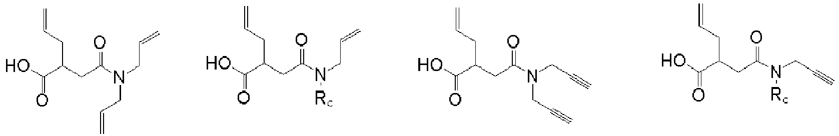

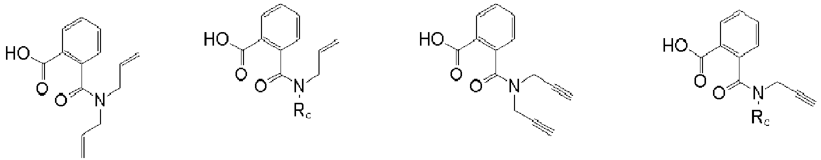

In the formulae, R_{c} represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms.

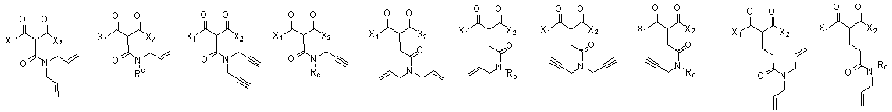

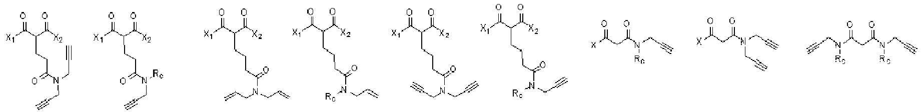

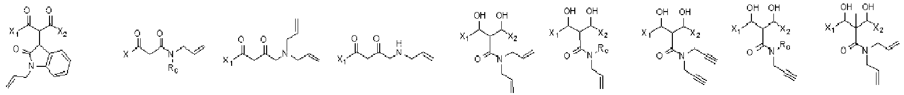

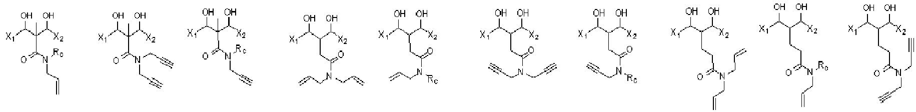

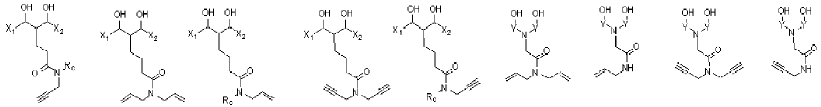

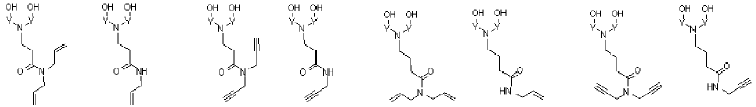

In the formulae, R_{c} represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms; X₁ and X₂ each represent a hydrocarbon group having 1 to 20 carbon atoms or an alkoxy group having 1 to 20 carbon atoms; and Y represents a divalent organic group having 1 to 10 carbon atoms.

Specific examples of ligands containing a crosslinking group represented by the general formulae (c-1) to (c-3) include the following compounds, but are not limited thereto.

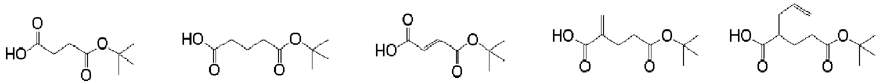

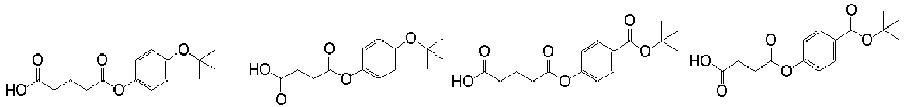

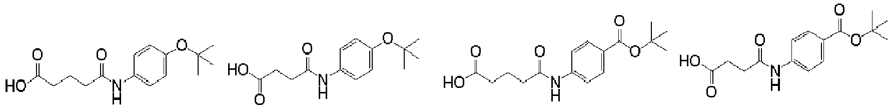

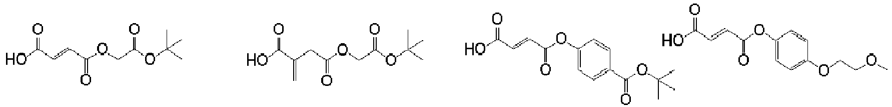

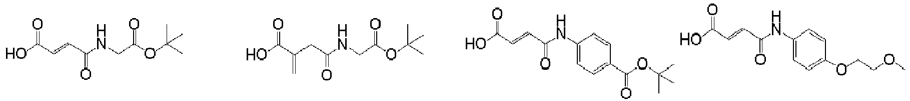

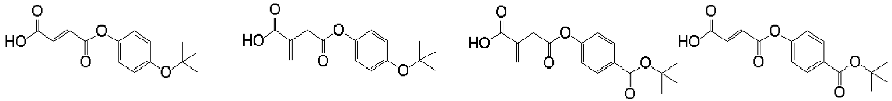

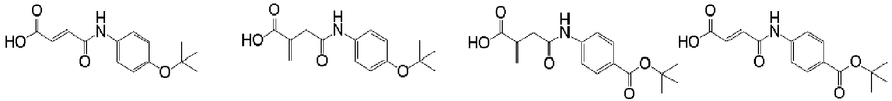

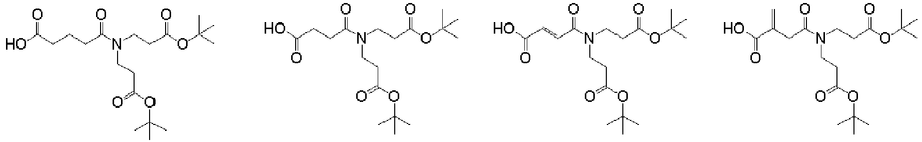

In the general formulae (c-1) to (c-3), one or more hydroxy groups or carboxy groups that are generated by the removal of a protecting group due to the action of an acid, heat, or both function as crosslinking groups.

The metal contained in the above-described metal compound is preferably titanium, zirconium, hafnium, or a combination thereof.

When the composition for forming a resist underlayer film contains a metal compound containing such a metal, the dry etching resistance at the time of substrate processing can be improved further.

As the metal compound, it is preferable to use further a compound containing a ligand derived from a silicon compound represented by the following general formula (2).

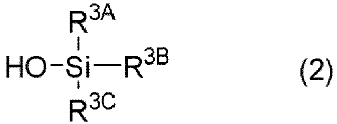

In the general formula (2), R^{3A}, R^{3B}, and R^{3C} each represent any organic group selected from an organic group having 2 to 30 carbon atoms and having any crosslinking group of a structure represented by the following general formulae (d-1) to (d-3), a substituted or unsubstituted alkyl group having 1 to 20 carbon atoms, and an aryl group having 6 to 20 carbon atoms.

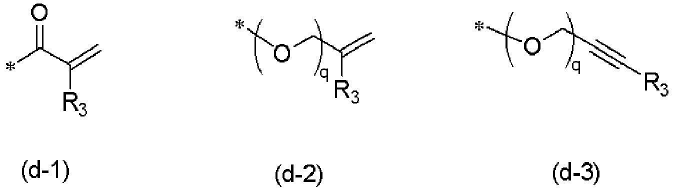

In the general formulae (d-1) to (d-3), R₃ represents a hydrogen atom or a monovalent organic group having 1 to 10 carbon atoms, "q" represents 0 or 1, and "*" represents an attachment point.

In the general formula (2), R^{3A}, R^{3B}, and R^{3C} each represent any organic group selected from an organic group having 2 to 30 carbon atoms and having any crosslinking group of a structure represented by one of the general formulae (d-1) to (d-3), a substituted or unsubstituted alkyl group having 1 to 20 carbon atoms, and an aryl group having 6 to 20 carbon atoms, preferably an organic group having 2 to 30 carbon atoms and having any crosslinking group of a structure represented by one of the general formulae (d-1) to (d-3) or an unsubstituted alkyl group having 1 to 10 carbon atoms. Among unsubstituted alkyl groups having 1 to 10 carbon atoms, a methyl group or an ethyl group is more preferable.

In the general formulae (d-1) to (d-3), each R₃ independently represents a hydrogen atom or a monovalent organic group having 1 to 10 carbon atoms; and each "q" independently represents 0 or 1.

When the above-described metal compound contains a ligand derived from a silicon compound represented by the general formula (2), the stability of the metal compound in the composition for forming a resist underlayer film is improved, and thus, it is possible to improve the flowability of the composition for forming a resist underlayer film.

From the viewpoint of thermosetting property, the ligand derived from a silicon compound represented by the general formula (2) more preferably has a structure represented by one of the following general formulae (2A) .

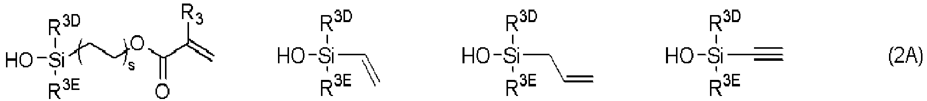

In the general formulae (2A), R^{3D} and R^{3E} each represent an organic group selected from a substituted or unsubstituted alkyl group having 1 to 20 carbon atoms and an aryl group having 6 to 20 carbon atoms; R₃ is as defined above; and "s" represents 1 to 10.

In the general formulae (2A), R^{3D} and R^{3E} are more preferably a methyl group from the viewpoint of the availability of raw materials.

When a crosslinking group is contained in the ligand derived from the silicon compound as well as in the ligand containing the crosslinking group represented by the general formulae (a-1) to (a-4), (b-1) to (b-4), and (c-1) to (c-3) in the metal compound, the thermosetting property of the composition for forming a resist underlayer film can be enhanced further. When such a compound is used in a composition for forming a resist underlayer film, it is possible to form a resist underlayer film having excellent filling and planarizing properties.

In the metal compound, the metal atom may be modified with a plurality of ligands having different structures or a ligand derived from a silicon compound as long as one or more ligands containing a crosslinking group represented by the general formulae (a-1) to (a-4), (b-1) to (b-4), and (c-1) to (c-3) are included, and the ligands can be adjusted appropriately depending on the required properties. The metal compound may also have a ligand other than the ligand containing a crosslinking group represented by the general formulae (a-1) to (a-4), (b-1) to (b-4), and (c-1) to (c-3) and the ligand derived from a silicon compound. For example, the compound may include a ligand derived from an alkyl group having 1 to 10 carbon atoms.

In the metal compound, the ligand containing a crosslinking group represented by the general formulae (a-1) to (a-4), (b-1) to (b-4), and (c-1) to (c-3) is preferably contained in an amount of 10 mol% to 100 mol%, more preferably 20 mol% to 80 mol% of the total amount of ligands coordinated to the metal atom. The ligand derived from a silicon compound is preferably contained in an amount of 0 mol% to 90 mol%, more preferably 20 mol% to 80 mol% of the total amount of ligands coordinated to the metal atom. The ligand other than the ligand containing a crosslinking group represented by the general formulae (a-1) to (a-4), (b-1) to (b-4), and (c-1) to (c-3) and the ligand derived from a silicon compound, for example, a ligand derived from an alkyl group having 1 to 10 carbon atoms, is preferably contained in an amount of 0 mol% to 50 mol%, more preferably 0 mol% to 20 mol% of the total amount of the ligands coordinated to the metal atom.

In the following, the components contained in the composition for forming a resist underlayer film to be used in the inventive method for forming a resist underlayer film other than the metal compound (A) will be described.

<(B) Organic Solvent>

The organic solvent (B) usable in the composition for forming a resist underlayer film used in the inventive method for forming a resist underlayer film is not particularly limited as long as the solvent can dissolve or disperse the metal compound (A) and, when contained, (C) a crosslinking agent, (E) a surfactant, (F) an acid generator, other additives, etc. described below.

Specifically, an organic solvent disclosed in paragraphs [0091] and [0092] in JP2007-199653A may be contained. More specifically, it is preferable to use propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more of these solvents.

The organic solvent is preferably contained in an amount of 200 to 10,000 parts by mass, more preferably 250 to 5,000 parts by mass relative to 100 parts by mass of the metal compound (A).

It is sufficient for the composition for forming a resist underlayer film to contain at least one kind of the above-described metal compound (A) and an organic solvent (B), and if necessary, the composition may also contain (C) a crosslinking agent, (E) a surfactant, and (F) an acid generator.

In the following, the components contained in the composition for forming a resist underlayer film used in the inventive method for forming a resist underlayer film other than the metal compound (A) will be described.

### <(B1) High-Boiling-Point Solvent>

In the composition for forming a resist underlayer film used in the inventive method for forming a resist underlayer film, the organic solvent (B) may be a mixture of one or more kinds of organic solvent having a boiling point of lower than 180°C and one or more kinds of organic solvent having a boiling point of 180°C or higher ((B1) a high-boiling-point solvent).

The high-boiling-point solvent (B1) is not particularly limited to hydrocarbons, alcohols, ketones, esters, ethers, or chlorine-based solvents as long as the solvent is capable of dissolving or dispersing the components of the composition for forming a resist underlayer film used in the inventive method for forming a resist underlayer film. Specific examples include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, dibutyl adipate, and the like. One of the solvents may be used or a mixture of two or more kinds may be used.

The high-boiling-point solvent (B1) may be selected suitably from the solvents above, for example, depending on the temperature at which the composition for forming a resist underlayer film used in the inventive method for forming a resist underlayer film is heat-treated, etc. The boiling point of the high-boiling-point solvent is preferably 180°C to 300°C, further preferably 200°C to 300°C. It is considered that when the boiling point is as described, sufficient thermal flowability can be achieved at the time of film formation, since there is no risk of excessive evaporation rate at the baking (heating). Thus, it is possible to form a resist underlayer film excellent in filling and planarizing properties. Moreover, a solvent having such a boiling point does not remain in the film without evaporating even after the baking. Therefore, there is no risk of the solvent adversely affecting the physical properties, such as etching resistance, of the film.

Furthermore, when the high-boiling-point solvent (B1) is used, the contained amount is preferably 1 to 30 parts by mass per 100 parts by mass of the organic solvent having a boiling point lower than 180°C. When the contained amount is as described, sufficient thermal flowability can be imparted at the time of baking, so that the solvent does not remain in the film and cause degradation in the physical properties, such as etching resistance, of the film. Therefore, such an amount is preferable.

### [(C) Crosslinking Agent]

To increase the curability of the metal compound and further inhibit intermixing with the resist upper layer film, the composition for forming a resist underlayer film used in the inventive method for forming a resist underlayer film may also contain a crosslinking agent (C). The crosslinking agent (C) is not particularly limited, and various known crosslinking agents can be widely used. Examples include melamine-based crosslinking agents, acrylate-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, epoxy-based crosslinking agents, and phenol-based crosslinking agents (e.g. polynuclear phenol-based, such as methylol- or alkoxymethyl-based crosslinking agents). The crosslinking agent (C) is preferably contained in an amount of 5 to 50 parts by mass, more preferably 10 to 40 parts by mass relative to 100 parts by mass of the metal compound (A).

Specific examples of the melamine-based crosslinking agents include hexamethoxymethylated melamine, hexabutoxymethylated melamine, alkoxy- and/or hydroxy-substituted derivatives thereof, and partial self-condensates thereof.

Specific examples of the acrylate-based crosslinking agents include dipentaerythritol hexaacrylate.

Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof.

Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof.

Specific examples of the urea-based crosslinking agents include dimethoxymethylated dimethoxyethyleneurea, alkoxy- and/or hydroxy-substituted derivatives thereof, and partial self-condensates thereof.

Specific examples of the β-hydroxyalkylamide-based crosslinking agent include N,N,N',N'-tetra(2-hydroxyethyl)adipic acid amide.

Specific examples of the isocyanurate-based crosslinking agents include triglycidyl isocyanurate and triallyl isocyanurate.

Specific examples of the aziridine-based crosslinking agents include 4,4'-bis(ethyleneiminocarbonylamino)diphenylmethane and 2,2-bishydroxymethylbutanol-tris[3-(1-aziridinyl)propionate].

Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylene bis-4,5-diphenyl-2-oxazoline, 2,2'-methylene bis-4-phenyl-2-oxazoline, 2,2'-methylene bis-4-tert-butyl-2-oxazoline, 2,2'-bis(2-oxazoline), 1,3-phenylene bis(2-oxazoline), 1,4-phenylene bis(2-oxazoline), and a 2-isopropenyloxazoline copolymer.

Specific examples of the epoxy-based crosslinking agents include diglycidyl ether, ethylene glycol diglycidyl ether, 1,4-butanediol diglycidyl ether, 1,4-cyclohexane dimethanol diglycidyl ether, poly(glycidyl methacrylate), trimethylolethane triglycidyl ether, trimethylolpropane triglycidyl ether, and pentaerythritol tetraglycidyl ether.

Specific examples of the polynuclear phenol-based crosslinking agents include compounds represented by the following general formula (XL-1).

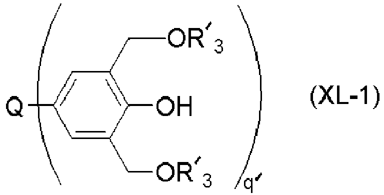

In the general formula (XL-1), Q represents a single bond or a q'-valent hydrocarbon group having 1 to 20 carbon atoms. R'₃ represents a hydrogen atom or an alkyl group having 1 to 20 carbon atoms. "q'" represents an integer of 1 to 5.

Q represents a single bond or a hydrocarbon group having a valency of "q'" and having 1 to 20 carbon atoms. "q'" represents an integer of 1 to 5, more preferably 2 or 3. Specific examples of Q include groups obtained by removing "q'" hydrogen atoms from methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane. R'₃ represents a hydrogen atom or an alkyl group having 1 to 20 carbon atoms. Specific examples of the alkyl group having 1 to 20 carbon atoms include a methyl group, an ethyl group, a propyl group, an isopropyl group, a butyl group, an isobutyl group, a pentyl group, an isopentyl group, a hexyl group, an octyl group, an ethylhexyl group, a decyl group, and an eicosanyl group. Among these, a hydrogen atom or a methyl group is preferable.

Specific examples of the compounds represented by the general formula (XL-1) include the following compounds. Among these, a hexamethoxymethylated derivative of triphenolmethane, triphenolethane, 1,1,1-tris(4-hydroxyphenyl)ethane, and tris(4-hydroxyphenyl)-1-ethyl-4-isopropylbenzene are preferable from the viewpoint of improving the curability and film thickness uniformity of the resist underlayer film. R'₃ is as defined above.

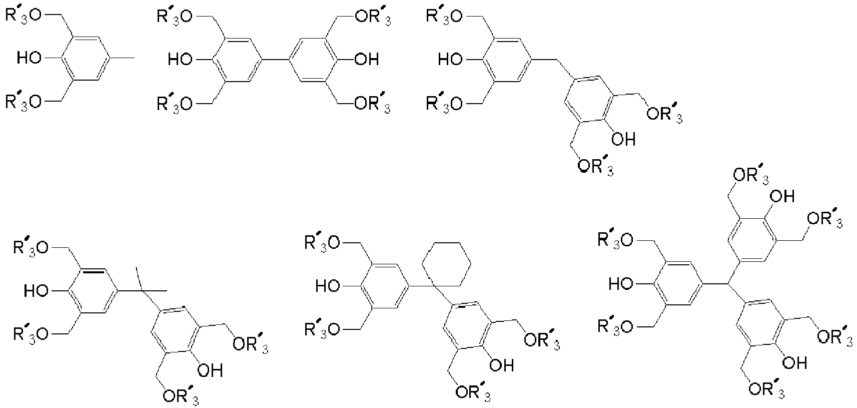

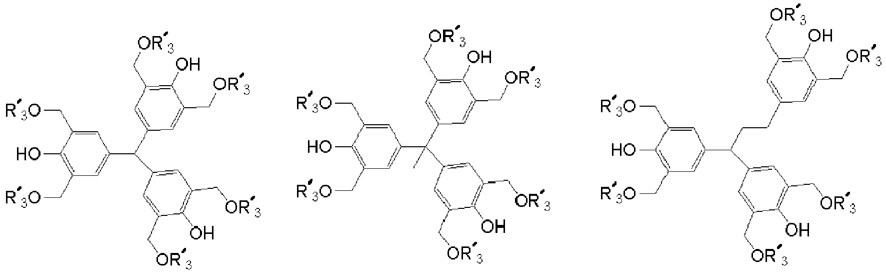

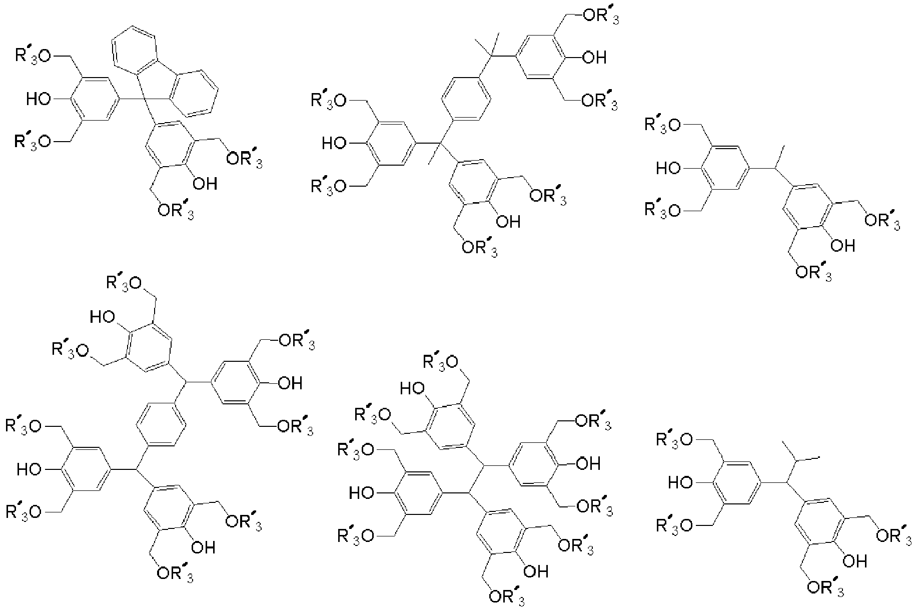

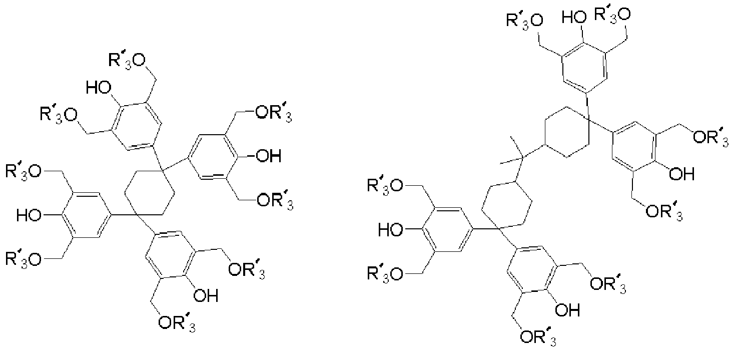

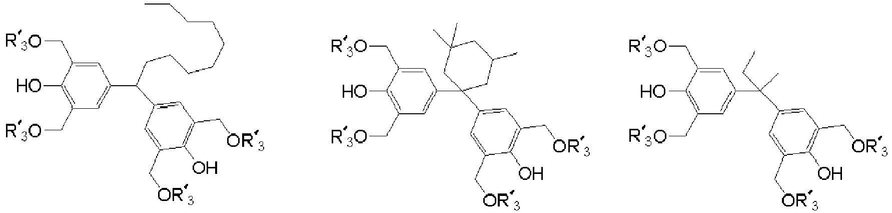

### <(E) Surfactant>

A surfactant (E) may be contained in the composition for forming a resist underlayer film used in the inventive method for forming a resist underlayer film in order to improve coating property in spin-coating. Examples of the surfactant (E) include those disclosed in paragraphs [0142] to [0147] of JP2009-269953A. When the surfactant (E) is contained, the contained amount is preferably 0.01 to 10 parts by mass, more preferably 0.05 to 5 parts by mass per 100 parts by mass of the metal compound (A).

### <(F) Acid Generator>

An acid generator (F) may be contained in the composition for forming a resist underlayer film used in the inventive method for forming a resist underlayer film in order to promote the curing reaction of the metal compound (A) further. The acid generator (F) can be classified into those that generate an acid by thermal decomposition and those that generate an acid by optical irradiation; however, any acid generator can be added. Specific examples of the acid generator include the materials disclosed in paragraphs [0061] to [0085] of JP2007-199653A, but are not limited thereto.

One kind of the acid generator (F) can be used, or two or more kinds can be used in combination. When an acid generator (F) is contained, the contained amount is preferably 0.05 to 50 parts by mass, more preferably 0.1 to 10 parts by mass relative to 100 parts by mass of the metal compound (A).

### <Other Additives>

In addition, in the composition for forming a resist underlayer film used in the inventive method for forming a resist underlayer film, it is preferable to use, as an additive for imparting filling and planarizing properties, for example, a liquid additive having a polyethylene glycol or polypropylene glycol structure, or a thermo-decomposable polymer having a mass reduction rate of 40% by mass or more on heating from 30°C to 250°C and a weight-average molecular weight of 300 to 200,000. This thermo-decomposable polymer preferably contains a repeating unit having an acetal structure represented by the following general formula (DP1) or (DP1a).

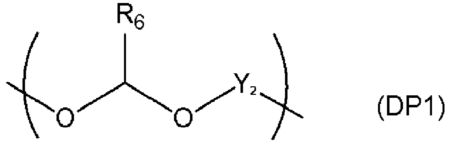

In the general formula (DP1), R₆ represents a hydrogen atom or a saturated or unsaturated monovalent organic group having 1 to 30 carbon atoms, the monovalent organic group optionally being substituted. Y₂ represents a saturated or unsaturated divalent organic group having 2 to 30 carbon atoms.

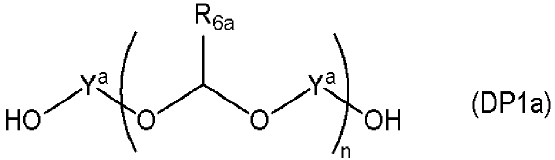

In the general formula (DP1a), R₆ₐ represents an alkyl group having 1 to 4 carbon atoms. Y^{a} represents a saturated or unsaturated divalent hydrocarbon group having 4 to 10 carbon atoms and optionally having an ether bond. "n" represents an average repeating unit number of 3 to 500.

### <Flowability Accelerator (BP)>

A flowability accelerator (BP) may be contained in the composition for forming a resist underlayer film used in the inventive method for forming a resist underlayer film as an additive for providing filling and planarizing properties. The flowability accelerator (BP) preferably has an organic group represented by the following general formulae (3) and an aromatic ring.

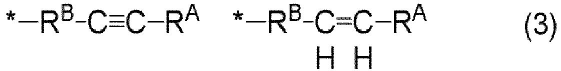

In the general formulae (3), "*" represents an attachment point to an oxygen atom. R^{B} represents a divalent organic group having 1 to 10 carbon atoms. R^{A} represents a hydrogen atom or a monovalent organic group having 1 to 10 carbon atoms.

When the flowability accelerator (BP) contains the organic group of the general formulae (3), thermal flowability and thermosetting property can be imparted to the composition for forming a resist underlayer film. Furthermore, when the flowability accelerator (BP) has an aromatic ring, degradation of the composition for forming a resist underlayer film in dry etching resistance can be alleviated.

The flowability accelerator (BP) preferably has at least one constitutional unit represented by the following general formulae (BP-1), (BP-2), (BP-3), (BP-4), and (BP-5).

### (Constitutional Units: BP-1, BP-2, and BP-3)

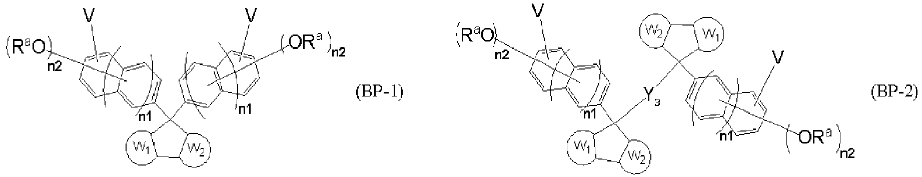

In the general formulae (BP-1) and (BP-2), W₁ and W₂ each independently represent a benzene ring or a naphthalene ring, part of hydrogen atoms in the benzene ring and the naphthalene ring optionally being substituted with a hydrocarbon group having 1 to 6 carbon atoms. R^{a} represents either group represented by the following formulae (4). Y₃ represents any group represented by the following formulae (5). Each "n1" represents 0 or 1. Each "n2" represents 1 or 2. Each V independently represents a hydrogen atom or an attachment point.

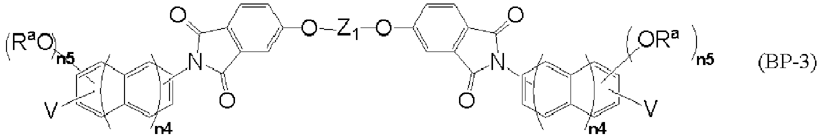

In the general formula (BP-3), Z₁ represents any group represented by the following general formulae (6); and each R^{a} represents either group represented by the following formulae (4). Each "n4" represents 0 or 1. Each "n5" represents 1 or 2. Each V independently represents a hydrogen atom or an attachment point.

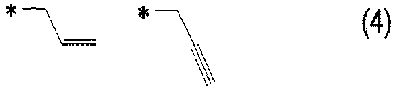

In the formulae (4), "*" represents an attachment point to an oxygen atom.

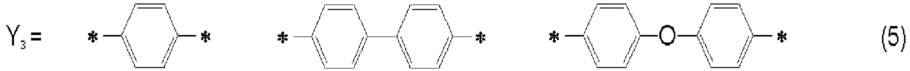

In the formulae (5), "*" represents an attachment point.

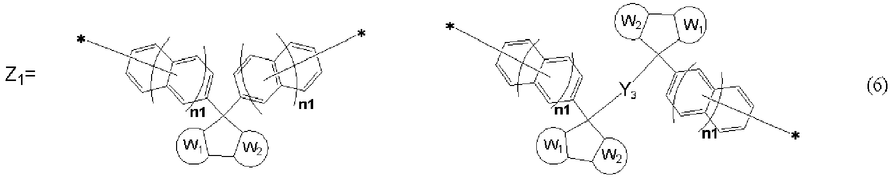

In the general formulae (6), W₁, W₂, Y₃, and "n1" are as defined above.

A resin having a constitutional unit represented by the general formulae (BP-1), (BP-2), and (BP-3) has excellent heat resistance, since a condensed carbon ring having a high carbon density including a cardo structure is introduced to the resin. Because the resin has such a characteristic, it is possible to form a resist underlayer film that can fill a stepped substrate without generating voids even when baked at a high temperature. Moreover, the resin is also excellent in dry etching resistance, and therefore, when the resin is contained in the composition for forming a resist underlayer film used in the inventive method for forming a resist underlayer film, heat resistance and thermal flowability can be imparted without great degradation of the excellent dry etching resistance that the metal compound has.

The resin having a constitutional unit represented by the general formulae (BP-1), (BP-2), and (BP-3) can be a compound represented by the following general formulae (bp-1), (bp-2), and/or (bp-3).

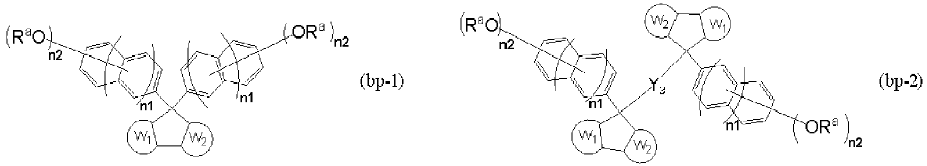

In the general formulae (bp-1) and (bp-2), W₁, W₂, R^{a}, Y₃, "n1", and "n2" are as defined above.

The W₁, W₂, R^{a}, Y₃, "n1", and "n2" in the general formulae (bp-1) and (bp-2) are as described in the description of the general formulae (BP-1) and (BP-2).

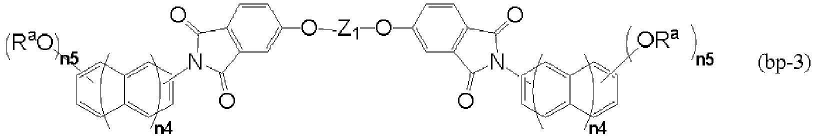

In the general formula (bp-3), Z₁, R^{a}, "n4", and "n5" are as defined above.

The Z₁, R^{a}, "n4", and "n5" in the general formula (bp-3) are as described in the description of the general formula (BP-3).

Specific examples of resins having a constitutional unit shown by the general formulae (bp-1), (bp-2), and (bp-3) include the following compounds, but are not limited thereto.

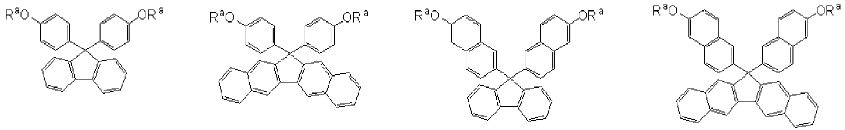

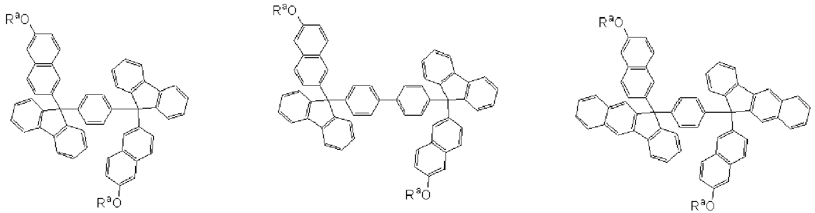

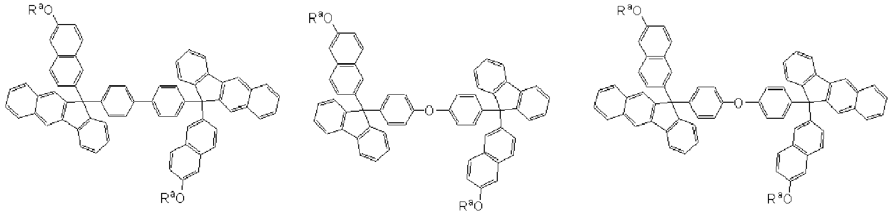

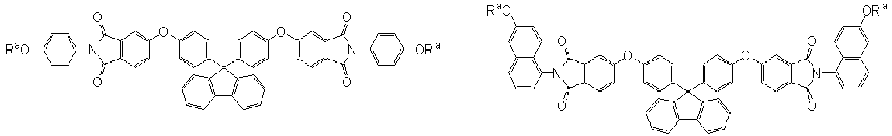

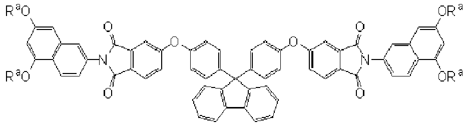

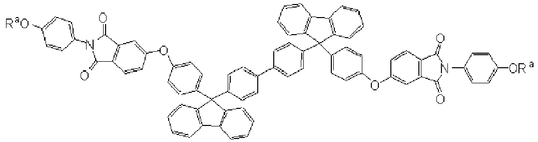

In the formulae, R^{a} is as defined above.

The compounds (bp-1), (bp-2), and (bp-3) preferably have a ratio Mw/Mn (that is, a dispersity) within the range of 1.00 ≤ Mw/Mn ≤ 1.25, further preferably 1.00 ≤ Mw/Mn ≤ 1.10, where Mw is a weight-average molecular weight and Mn is a number-average molecular weight measured by gel permeation chromatography in terms of polystyrene.

A compound having a dispersity within such a range provides the composition for forming a resist underlayer film with even better thermal flowability. Thus, it is possible to provide a composition for forming a resist underlayer film having even better filling and planarizing properties when the compound is contained in a composition for forming a resist underlayer film.

The resin having a constitutional unit represented by the general formulae (BP-1), (BP-2), and (BP-3) may be a polymer having a repeating unit represented by the following general formulae (bp-4), (bp-5), and/or (bp-6).

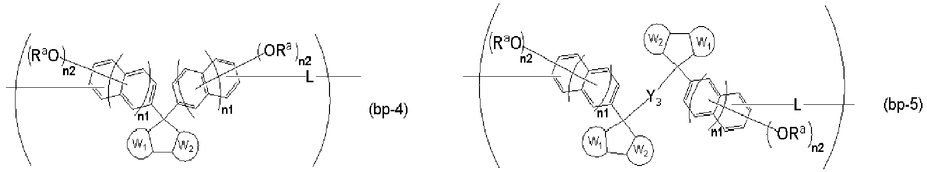

In the general formulae (bp-4) and (bp-5), W₁, W₂, R^{a}, Y₃, "n1", and "n2" are as defined above, and L represents a divalent organic group having 1 to 40 carbon atoms.

The W₁, W₂, R^{a}, Y₃, "n1", and "n2" in the general formulae (bp-4) and (bp-5) are as described in the description of the general formulae (BP-1) and (BP-2).

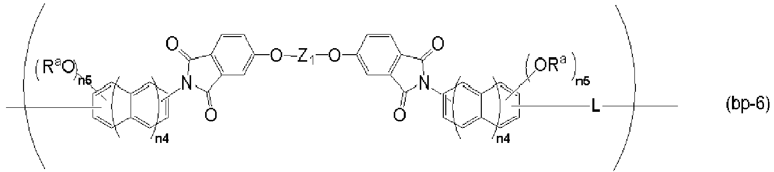

In the general formula (bp-6), Z₁, R^{a}, "n4", and "n5" are as defined above, and L represents a divalent organic group having 1 to 40 carbon atoms.

The Z₁, R^{a}, "n4", and "n5" in the general formula (bp-6) are as described in the description of the general formula (BP-3).

The polymer is obtained with compounds represented by the general formulae (bp-1), (bp-2), and (bp-3), and because the compounds are used, the polymer has excellent dry etching resistance and heat resistance. In addition, since the polymer is not a monomer but a polymer having repeating units, the amount of outgas component is small, and the polymer has a molecular weight distribution; therefore, crystallinity is alleviated, and improved film forming property can also be expected.

L, which is a linking group contained in the repeating units of the general formulae (bp-4), (bp-5), and (bp-6), is a divalent organic group having 1 to 40 carbon atoms, and specific examples include the following.

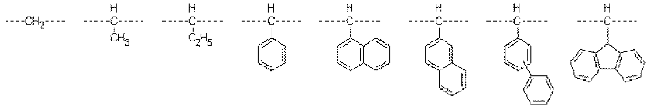

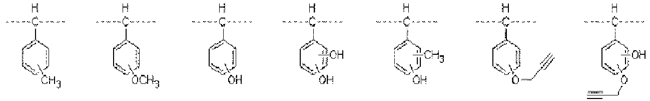

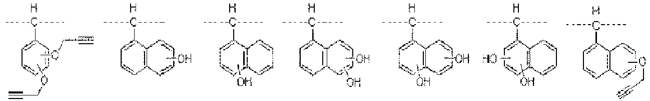

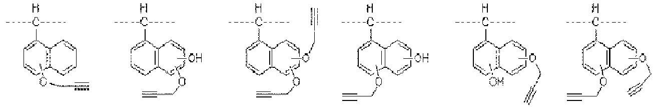

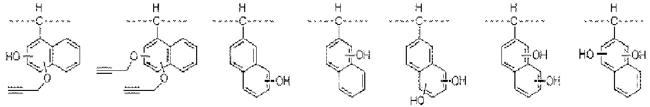

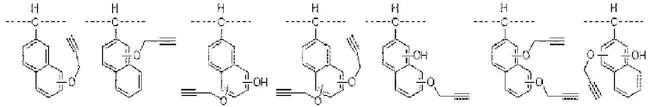

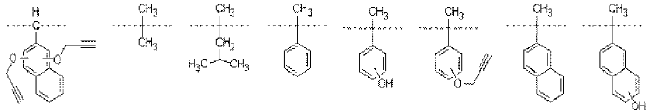

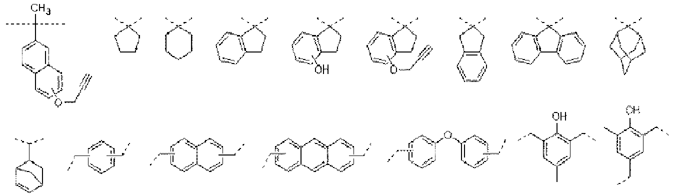

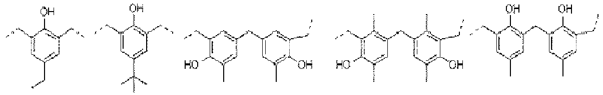

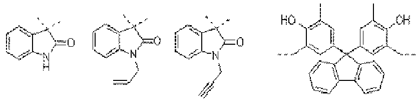

Furthermore, the linking group L of the polymer is preferably as in the following general formula (10).

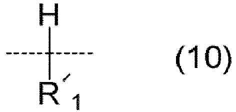

In the general formula (10), R'₁ represents a hydrogen atom or an organic group having 6 to 20 carbon atoms and including an aromatic ring, and a broken line represents an attachment point.

Specific examples of the general formula (10) include the following. In particular, in view of the availability of raw materials, a methylene group is preferable, that is, R'₁ is preferably a hydrogen atom.

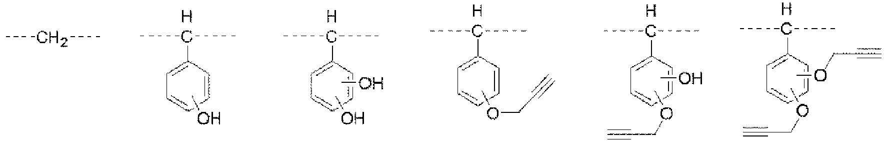

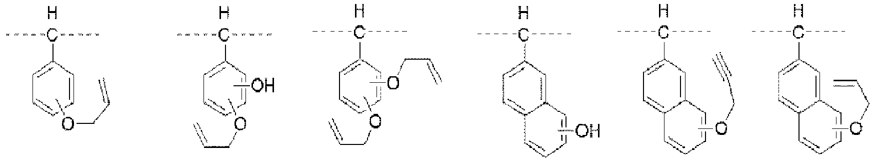

Furthermore, the polymer having the repeating structural units represented by the general formulae (bp-4), (bp-5), and (bp-6) preferably has a weight-average molecular weight (Mw) of 1,000 to 12,000, further preferably 2,000 to 10,000 as measured by gel permeation chromatography in terms of polystyrene.

When the molecular weight is within such a range, solubility in an organic solvent can be ensured, and it is possible to suppress sublimation products that are generated during baking. Furthermore, the thermal flowability of the composition for forming a resist underlayer film is improved, and therefore, it is possible to provide a composition for forming a resist underlayer film having better filling and planarizing properties when the polymer is contained in a composition for forming a resist underlayer film.

### (Constitutional Unit: BP-4)

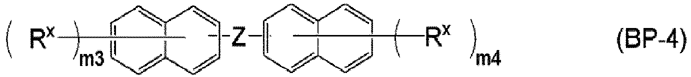

In the general formula (BP-4), "m3" and "m4" represent 1 or 2. Z represents a single bond or any structure represented by the following general formulae (7). R^{x} represents any structure represented by the following general formulae (8).

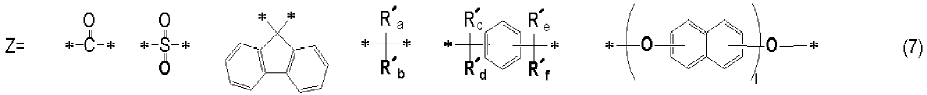

In the general formulae (7), "*" represents an attachment point. "l" represents an integer of 0 to 3. R'ₐ to R'_{f} each independently represent a hydrogen atom, an alkyl group having 1 to 10 carbon atoms and optionally having a substituent fluorine atom, a phenyl group, or a phenylethyl group, R'ₐ and R'_{b} optionally being bonded to each other to form a cyclic compound.

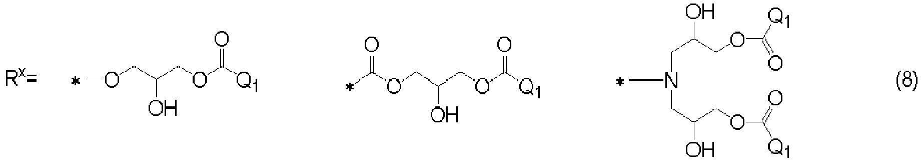

In the general formulae (8), "*" represents an attachment point to an aromatic ring. Each Q₁ represents a linear saturated hydrocarbon group having 1 to 30 carbon atoms or a structure represented by the following general formula (9).

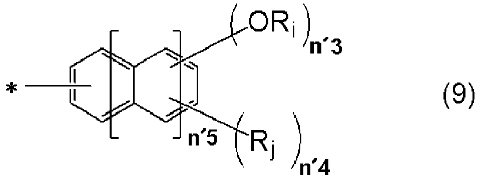

In the general formula (9), "*" represents an attachment point to a carbonyl group. Rᵢ represents either group represented by the formulae (4). Rⱼ represents a linear or branched hydrocarbon group having 1 to 10 carbon atoms, a halogen atom, a nitro group, an amino group, a nitrile group, an alkoxycarbonyl group having 2 to 10 carbon atoms, or an alkanoyloxy group having 2 to 10 carbon atoms. "n'3" and "n'4" each represent a number of substituents on an aromatic ring, the number each representing an integer of 0 to 7, provided that n'3+n'4 is 0 or more and 7 or less. "n'5" represents 0 to 2.

In the general formula (BP-4), "m3" and "m4" represent 1 or 2, and Z represents a single bond or one of the structures represented by the general formulae (7). R^{x} represents one of the structures represented by the general formulae (8).

From the viewpoint of dry etching resistance and heat resistance, the Z in the general formula (BP-4) is preferably a single bond or one of the structures represented by the following general formulae (4A).

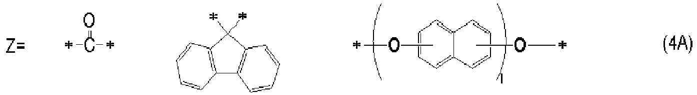

In the general formulae (4A), "*" represents an attachment point, and "l" is as defined above.

In the general formulae (8), "*" represents an attachment point to an aromatic ring. Each Q₁ represents a linear saturated hydrocarbon group having 1 to 30 carbon atoms or a structure represented by the general formula (9). When Q₁ represents a linear hydrocarbon group having 1 to 30 carbon atoms, methylene groups constituting Q₁ may be substituted with an oxygen atom or a carbonyl group. From the viewpoints of dry etching resistance and heat resistance, Q₁ preferably has a structure represented by the general formula (9).

In the general formula (9), "*" represents an attachment point to a carbonyl group, and each Rᵢ represents one of the groups represented by the formulae (4). Each Rⱼ represents a linear or branched hydrocarbon group having 1 to 10 carbon atoms, a halogen atom, a nitro group, an amino group, a nitrile group, an alkoxycarbonyl group having 2 to 10 carbon atoms, or an alkanoyloxy group having 2 to 10 carbon atoms. "n'3" and "n'4" each represent the number of substituents on an aromatic ring, and each represent an integer of 0 to 7, provided that n'3+n'4 is 0 or more and 7 or less. "n'5" represents 0 to 2.

A compound containing a constitutional unit represented by the general formula (BP-4) has a structure in which aromatic rings are linked by a single bond or one of the general formulae (7), and therefore, has a high carbon density. Accordingly, a composition for forming a resist underlayer film containing such a compound has excellent heat resistance. Meanwhile, the structure of the linking group Z can be selected appropriately from various linking groups in accordance with the desired performance, as shown in the general formulae (7). In particular, by introducing a structure represented by one of the general formulae (4A) as the Z, heat resistance and etching resistance can be provided without film forming property being degraded. Moreover, since the compound has a highly flexible terminal moiety R^{x}, the composition for forming a resist underlayer film can be formed into a thick film without generating defects such as cracks, even though the compound includes a rigid aromatic ring structure. Furthermore, the terminal moiety R^{x} includes a terminal group Q₁ that provides thermal flowability. As the terminal group Q₁, it is possible to introduce at any proportion a flexible hydrocarbon structure that contributes to the improvement of thermal flowability and a rigid aromatic ring structure that contributes to etching resistance and heat resistance, depending on the required performance. As described above, a composition for forming a resist underlayer film containing such a compound can realize high levels of filling and planarizing properties and heat resistance, and in accordance with required properties, a thick film can be formed.

### (Constitutional Unit: BP-5)

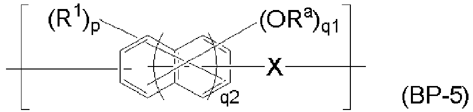

In the general formula (BP-5), each R¹ represents a saturated monovalent organic group having 1 to 30 carbon atoms or an unsaturated monovalent organic group having 2 to 30 carbon atoms. X represents a divalent organic group having 1 to 30 carbon atoms. Each R^{a} represents either group represented by the formulae (4). "p" represents an integer of 0 to 5 and "q₁" represents an integer of 1 to 6, provided that p+q₁ is an integer of 1 or more and 6 or less. "q₂" represents 0 or 1.

Examples of the divalent organic group having 1 to 30 carbon atoms represented by X in the general formula (BP-5) include: alkanediyl groups, such as a methylene group, an ethanediyl group, a propanediyl group, a butanediyl group, a pentanediyl group, a hexanediyl group, an octanediyl group, and a decanediyl group; monocyclic cycloalkanediyl groups, such as a cyclopropanediyl group, a cyclobutanediyl group, a cyclopentanediyl group, a cyclohexanediyl group, a cycloheptanediyl group, a cyclooctanediyl group, a cyclodecanediyl group, a methylcyclohexanediyl group, and an ethylcyclohexanediyl group; polycyclic cycloalkanediyl groups, such as a bicyclo[2.2.1]heptanediyl group, a bicyclo[2.2.2]octanediyl group, a tricyclo[5.2.1.0^{2,6}]decanediyl group (a dicyclopentylene group), a tricyclo[3.3.1.1^{3,7}]decanediyl group, a tetracyclo [6.2.1.1^{3,6}.0^{2,7}] dodecanediyl group, and an adamantanediyl group; and arenediyl groups, such as a phenylene group and a naphthylene group.

Examples of alkanediyloxy groups represented by the X include groups containing a combination of the above alkanediyl group and an oxygen atom. Meanwhile, examples of cycloalkanediyloxy groups represented by the X include groups containing a combination of the above cycloalkanediyl group and an oxygen atom.

Part or all of the hydrogen atoms in the alkanediyl groups, cycloalkanediyl groups, alkanediyloxy groups, cycloalkanediyloxy groups, arenediyl groups, etc. may be substituted, and examples of substituents include the groups that are examples of substituents that the organic group represented by R^{a} may have.

Examples of the organic group represented by X include groups represented by the following formulae and so forth.

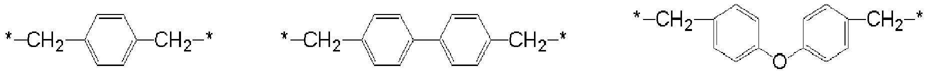

In the formulae, "*" represents an attachment point.

The X is preferably a methylene group from the viewpoint of the availability of raw materials.

Specific examples of the resin having a structural unit represented by the general formula (BP-5) include the following.

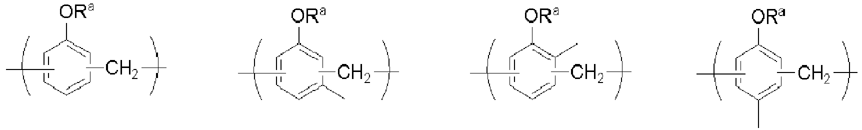

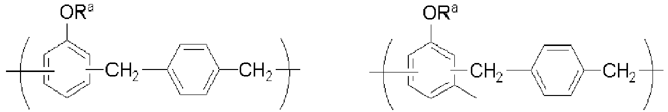

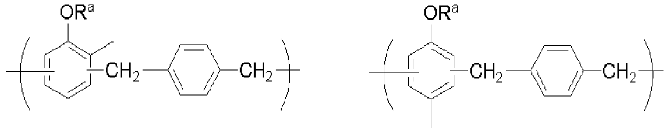

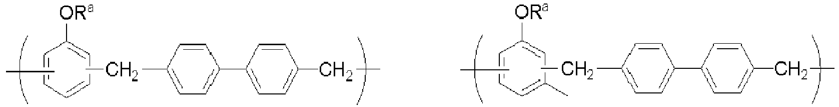

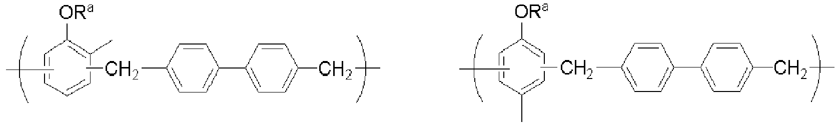

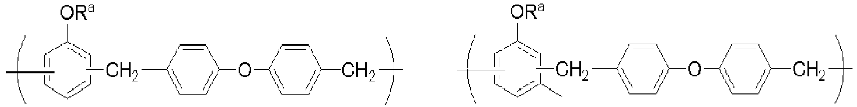

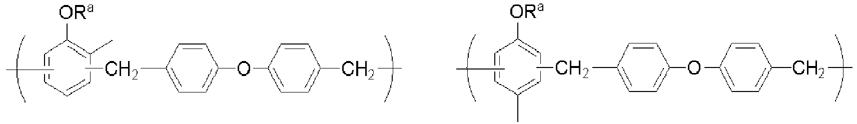

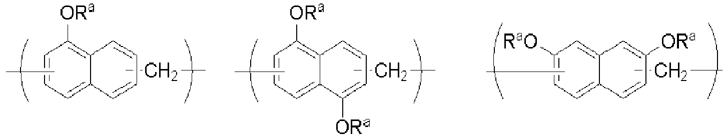

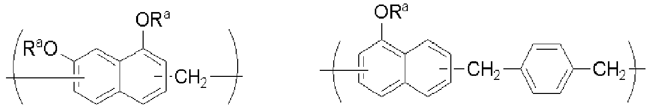

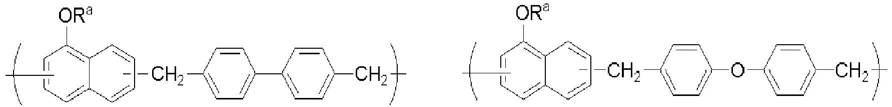

In the formulae, R^{a} is as defined above.

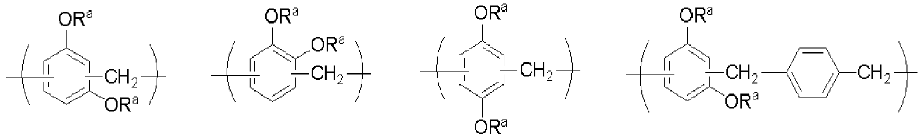

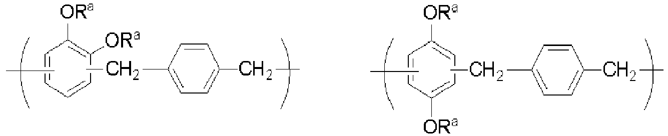

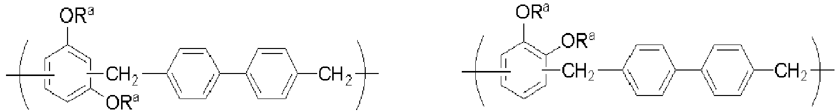

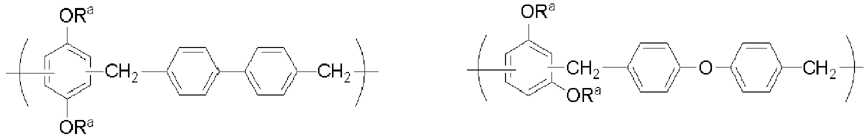

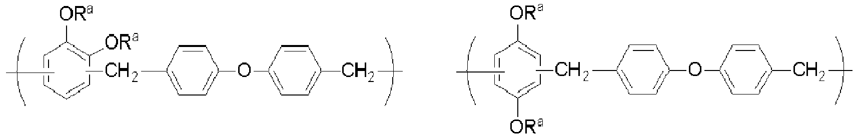

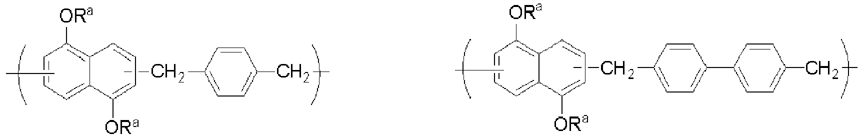

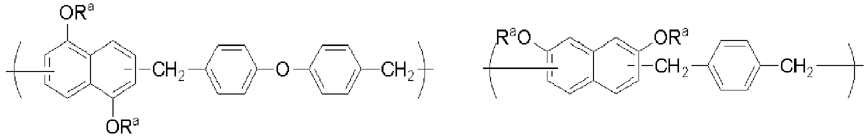

In the formulae, R^{a} is as defined above.

A polymer containing the constitutional unit represented by the general formula (BP-5) has a structure in which aromatic rings are linked by an organic group X, and has a high carbon density. Accordingly, a composition for forming a resist underlayer film containing such a polymer exhibits high dry etching resistance, and also has excellent heat resistance. Furthermore, an organic group, which contributes to the improvement of thermal flowability, having a structure represented by the formulae (4) is bonded directly to an aromatic ring via an oxygen atom, the aromatic ring being a mother nucleus structure of the resin. Therefore, a composition for forming a resist underlayer film containing such a polymer can achieve high levels of filling and planarizing properties, and also of heat resistance and etching resistance. Furthermore, the aromatic structure of the mother nucleus is not excessively rigid, and forms a repeating structure through the organic group X, being a linking group, and therefore, a resist underlayer film can be formed without generating defects such as cracks.

In the composition for forming a resist underlayer film to be used in the inventive method for forming a resist underlayer film, the flowability accelerator (BP) is preferably contained in an amount of 50% by mass or less, more preferably 30% by mass or less, and further preferably 20% by mass or less based on 100 parts by mass of the metal compound.

The amount of the flowability accelerator to be added can be adjusted to any proportion, depending on the properties required in the process in which the composition for forming a resist underlayer film to be used in the inventive method for forming a resist underlayer film is used. When it is desired to minimize the degradation of dry etching resistance, the proportion of the flowability accelerator can be reduced. When the degradation of dry etching resistance can be tolerated to some extent, and it is desired to improve the filling and planarizing properties further, the proportion of the flowability accelerator can be increased.

### <Patterning Process Using Method for Forming Resist Underlayer Film>

In addition, the present invention provides, as a patterning process according to a two-layer resist process using the above-described method for forming a resist underlayer film, a patterning process including:
forming a resist underlayer film on a substrate to be processed by using the above-described method for forming a resist underlayer film;
forming a resist upper layer film on the resist underlayer film by using a photoresist material;
subjecting the resist upper layer film to pattern exposure and then development with a developer to form a pattern in the resist upper layer film;
transferring the pattern to the resist underlayer film by dry etching while using the resist upper layer film having the formed pattern as a mask; and
processing the substrate to be processed while using the resist underlayer film having the formed pattern as a mask to form the pattern in the substrate to be processed.

The resist upper layer film in the two-layer resist process described above exhibits etching resistance with respect to chlorine-based gas. Therefore, the dry etching of the resist underlayer film that is performed while using the resist upper layer film as a mask in the two-layer resist process is preferably performed using an etching gas mainly containing a chlorine-based gas.

The present invention also provides, as a patterning process according to a three-layer resist process using the above-described method for forming a resist underlayer film, a patterning process for forming a pattern in a substrate to be processed, including the steps of:
(I-1) forming a resist underlayer film on a substrate to be processed by the above-described method for forming a resist underlayer film;
(I-2) forming a silicon-containing resist middle layer film on the resist underlayer film;
(I-3) forming a resist upper layer film on the silicon-containing resist middle layer film by using a photoresist material;
(I-4) subjecting the resist upper layer film to pattern exposure and then development with a developer to form a pattern in the resist upper layer film;
(I-5) transferring the pattern to the silicon-containing resist middle layer film by dry etching while using the resist upper layer film having the formed pattern as a mask;
(I-6) transferring the pattern to the resist underlayer film by dry etching while using the silicon-containing resist middle layer film having the transferred pattern as a mask; and
(I-7) processing the substrate to be processed while using the resist underlayer film having the formed pattern as a mask to form the pattern in the substrate to be processed.

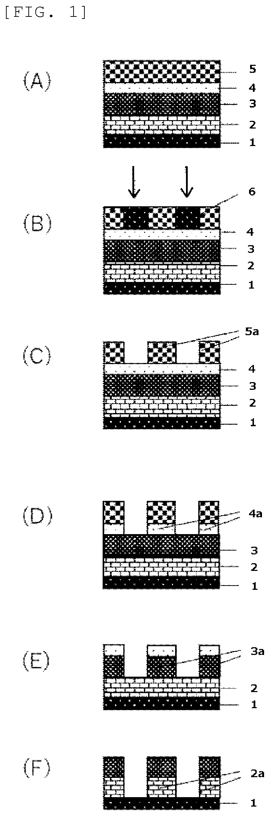

With reference to FIG. 1, a patterning process according to a three-layer resist process will be described. The present invention provides, as a patterning process according to a three-layer resist process using such a method for forming a resist underlayer film, the patterning process including:
forming a resist underlayer film 3 on a layer 2 to be processed on a substrate 1 to be processed by using the method for forming a resist underlayer film, forming a silicon-containing resist middle layer film 4 on the resist underlayer film by using a silicon-containing resist middle layer film material, and forming a resist upper layer film 5 on the silicon-containing resist middle layer film by using a photoresist material as in FIG. 1(A);
subsequently subjecting an exposure portion 6 of the resist upper layer film to pattern exposure as in FIG. 1(B) and then development with a developer to form a resist upper layer film pattern 5a in the resist upper layer film as in FIG. 1(C);
transferring a silicon-containing resist middle layer film pattern 4a to the silicon-containing resist middle layer film by dry etching while using the resist upper layer film having the formed pattern as a mask as in FIG. 1(D);
transferring a resist underlayer film pattern 3a to the resist underlayer film by dry etching while using the silicon-containing resist middle layer film having the transferred pattern as a mask as in FIG. 1(E); and
processing the layer to be processed on the substrate to be processed while using the resist underlayer film having the formed pattern as a mask to form a pattern 2a on the substrate 1 to be processed as in FIG. 1(F).

The silicon-containing resist middle layer film in the three-layer resist process exhibits etching resistance with respect to a chlorine-based gas. Therefore, the dry etching of the resist underlayer film that is performed while using the silicon-containing resist middle layer film as a mask in the three-layer resist process is preferably performed using an etching gas mainly containing a chlorine-based gas.

As the silicon-containing resist middle layer film in the three-layer resist process, a polysiloxane-based middle layer film is also preferably used. This allows the silicon-containing resist middle layer film to possess an effect as an antireflective film, thereby suppressing reflection. When a material containing many aromatic groups and having a high etching selectivity with respect to the substrate is used as the organic film especially for 193-nm exposure, the k-value increases and thus the substrate reflection increases; however, the reflection can be suppressed by imparting absorption in such a manner that the silicon-containing resist middle layer film has an appropriate k-value. In this manner, the substrate reflection can be reduced to 0.5% or less. Preferably used as the silicon-containing resist middle layer film having an antireflective effect is a polysiloxane, which has a pendant anthracene for exposure at 248 nm or 157 nm, or a pendant phenyl group or a pendant light-absorbing group having a silicon-silicon bond for 193 nm exposure, and which is crosslinked by an acid or heat.

In addition, the present invention provides a patterning process by way of a four-layer resist process using such a method for forming a resist underlayer film, the patterning process including the steps of:
forming a resist underlayer film on a substrate to be processed by using the above-described method for forming a resist underlayer film;
forming a silicon-containing resist middle layer film on the resist underlayer film by using a silicon-containing resist middle layer film material;
forming an organic antireflective film (BARC) or an adhesive film on the silicon-containing resist middle layer film;
forming a resist upper layer film on the BARC or the adhesive film by using a photoresist material;
subjecting the resist upper layer film to pattern exposure and then development with a developer, thereby forming a pattern in the resist upper layer film;
transferring the pattern to the BARC or the adhesive film and the silicon-containing resist middle layer film by dry etching while using the resist upper layer film having the formed pattern as a mask;
transferring the pattern to the resist underlayer film by dry etching while using the silicon-containing resist middle layer film having the transferred pattern as a mask; and
processing the substrate to be processed while using the resist underlayer film having the formed pattern as a mask, thereby forming the pattern in the substrate to be processed.

Alternatively, an inorganic hard mask middle layer film may be formed instead of the silicon-containing resist middle layer film. In this case, a semiconductor device circuit pattern can be formed on a substrate, at least, by:
forming a resist underlayer film on a body to be processed by using the inventive method for forming a resist underlayer film;
forming an inorganic hard mask middle layer film selected from the group consisting of a silicon oxide film, a silicon nitride film, and a silicon oxynitride film on the resist underlayer film;
forming a resist upper layer film on the inorganic hard mask middle layer film by using a photoresist composition;
forming a circuit pattern in the resist upper layer film;
etching the inorganic hard mask middle layer film while using the resist upper layer film having the formed pattern as a mask;
etching the resist underlayer film while using the inorganic hard mask middle layer film having the formed pattern as a mask; and
further etching the body to be processed while using the resist underlayer film having the formed pattern as a mask to form the pattern in the body to be processed.

As described above, when the inorganic hard mask middle layer film is formed on the resist underlayer film, a silicon oxide film, a silicon nitride film, and a silicon oxynitride film (SiON film) can be formed by a CVD method, an ALD method, etc. The method for forming the silicon nitride film is disclosed, for example, in JP2002-334869A and WO2004/066377A1. The film thickness of the inorganic hard mask middle layer film is preferably 5 to 200 nm, more preferably 10 to 100 nm. The SiON film, which has a high function as an antireflective film, is the most favorably used as the inorganic hard mask middle layer film. Since the substrate temperature increases to 300 to 500°C when the SiON film is formed, the resist underlayer film needs to withstand a temperature of 300 to 500°C. The composition for forming a resist underlayer film used in the present invention has high heat resistance and can withstand a high temperature of 300 to 500°C. Thus, the resist underlayer film formed by spin-coating and the inorganic hard mask middle layer film formed by the CVD method or the ALD method can be combined.

A photoresist film may be formed on the inorganic hard mask middle layer film as the resist upper layer film as described above. Alternatively, an organic antireflective film (BARC) or an adhesive film may be formed on the inorganic hard mask middle layer film by spin-coating, and a photoresist film may be formed thereon. In particular, when a SiON film is used as the inorganic hard mask middle layer film, the reflection can be suppressed by the two antireflective films, i.e., the SiON film and the BARC film, even in liquid immersion exposure at a high NA exceeding 1.0. Another merit of forming BARC resides in that it has an effect of reducing a footing profile of a photoresist pattern immediately above the SiON film.

The present invention also provides a patterning process for forming a pattern in a substrate to be processed, including the steps of:
(II-1) forming a resist underlayer film on a substrate to be processed by the above-described method for forming a resist underlayer film;
(II-2) forming an inorganic hard mask middle layer film selected from the group consisting of a silicon oxide film, a silicon nitride film, and a silicon oxynitride film on the resist underlayer film;
(II-3) forming an organic thin film on the inorganic hard mask middle layer film;
(II-4) forming a resist upper layer film on the organic thin film by using a photoresist material;
(II-5) subjecting the resist upper layer film to pattern exposure and then development with a developer to form a pattern in the resist upper layer film;
(II-6) transferring the pattern to the organic thin film and the inorganic hard mask middle layer film by dry etching while using the resist upper layer film having the formed pattern as a mask;
(II-7) transferring the pattern to the resist underlayer film by dry etching while using the inorganic hard mask middle layer film having the transferred pattern as a mask; and
(II-8) processing the substrate to be processed while using the resist underlayer film having the formed pattern as a mask to form the pattern in the substrate to be processed.

In the above-described patterning process, the resist upper layer film may be either a positive type or a negative type, and it is possible to use a film similar to the typically used photoresist composition. The photoresist composition may also contain a metal atom such as Sn, In, Ga, Ge, Al, Ce, La, Cs, Zr, Hf, Ti, Bi, Sb, and Zn. In a case where the resist upper layer film is formed with the photoresist composition, a spin-coating method may be employed, or the film may be formed by a deposition treatment by a CVD method or an ALD method.

In a case where the resist upper layer film is formed by a spin-coating method, prebaking is conducted after applying the photoresist composition. The prebaking is preferably performed at 60 to 180°C for 10 to 300 seconds. Thereafter, exposure is conducted according to a usual manner, followed by post-exposure baking (PEB) and development, thereby obtaining a resist upper layer film pattern. Although the thickness of the resist upper layer film is not particularly limited, the thickness is preferably 10 to 500 nm, particularly preferably 20 to 400 nm.

In a case where the resist upper layer film is to be formed by a deposition treatment according to a CVD method or an ALD method, the photoresist composition is a metal oxide-containing film having photosensitivity to EUV, and the metal is selected from Sn, Zr, Hf, Ti, Bi, Sb, etc. In particular, Sn, which has excellent photosensitivity to EUV, is preferable. The metal oxide-containing film may be a photosensitive organometallic oxide film such as an organotin oxide (for example, haloalkyl Sn, alkoxyalkyl Sn, or amidoalkyl Sn). Some specific examples of suitable precursors include trimethyl tin chloride, dimethyletin dichloride, methyltin trichloride, tris(dimethylamino)methyl tin(IV), and (dimethylamino)trimethyl tin(IV).

The metal oxide-containing film may be deposited by PECVD or PEALD, for example, by using a Lam Vector (registered trademark) tool, separating the Sn oxide precursor from O precursor/plasma in the ALD implementation. Deposition temperature is preferably 50°C to 600°C. Deposition pressure is preferably between 100 and 6,000 mTorr. Precursor liquid flow rates for metal oxide-containing film (e.g., an organotin oxide precursor) can be 0.01 to 10 cmm, and gas flow rates (CO₂, CO, Ar, and N₂) can be 100 to 10,000 sccm. Plasma powers can be 200 to 1,000 W per 300 mm wafer station, using a high-frequency plasma (e.g., 13.56 MHz, 27.1 MHz, or higher). Deposited thickness is preferably 100 to 2,000 Å.

Examples of light for exposure include high-energy beams at wavelengths of 300 nm or less, specifically excimer lasers at 248 nm, 193 nm, and 157 nm, soft X-rays at 3 to 20 nm, an electron beam, X-rays, and the like.

As the method for forming a pattern in the resist upper layer film, it is preferable to use a patterning process using a photolithography with a wavelength of 5 nm or more and 300 nm or less, a direct drawing using an electron beam, nanoimprinting, or a combination thereof.

The development method in the patterning process is preferably alkali development or development using an organic solvent.

Next, etching is performed while using the obtained resist upper layer film pattern as a mask. The etching of a silicon-containing resist middle layer film or an inorganic hard mask middle layer film in the three-layer resist process is performed while using the resist upper layer film pattern as a mask by using a fluorocarbon-based gas. In this manner, a silicon-containing resist middle layer film pattern or an inorganic hard mask middle layer film pattern is formed.

Next, the resist underlayer film is etched while using the obtained silicon-containing resist middle layer film pattern or inorganic hard mask middle layer film pattern as a mask. The etching of the resist underlayer film is preferably performed using an etching gas mainly containing a chlorine-based gas.

The subsequent etching of a body to be processed may also be performed according to a usual manner. For example, in the case of a body to be processed made of SiO₂, SiN or silica-based low dielectric constant insulating film, the etching is performed mainly based on a fluorocarbon-based gas. When the substrate is processed by way of etching with a fluorocarbon-based gas, the silicon-containing resist middle layer film pattern in the three-layer resist process is stripped simultaneously with the substrate processing.

The resist underlayer film obtained by the inventive method for forming a resist underlayer film is characterized by its excellent etching resistance at the time of etching of the body to be processed.

Examples of the body to be processed (substrate to be processed) include, but are not particularly limited to, substrates made of Si, α-Si, p-Si, SiO₂, SiN, SiON, W, TiN, Al, etc., those in which the layers to be processed are formed on the substrate, and the like. Examples of the layers to be processed include various low-k films such as those made of Si, SiO₂, SiON, SiN, p-Si, α-Si, W, W-Si, Al, Cu, Al-Si, and the like, and stopper films therefor, which can each be typically formed into a thickness of 50 to 10,000 nm, particularly 100 to 5,000 nm. When the layer to be processed is formed, the substrate and the layer to be processed are made of different materials.

In the patterning process using the inventive method for forming a resist underlayer film, it is preferable to use a substrate to be processed having a structure or step having a height of 30 nm or more. As described above, the composition for forming a resist underlayer film used in the inventive method for forming a resist underlayer film has excellent filling and planarizing properties, so that a flat resist underlayer film can be formed even when the substrate to be processed has a step (irregularities) or structure having a height of 30 nm or more. The height of the structure or step of the substrate to be processed is preferably 30 nm or more, more preferably 50 nm or more, and further preferably 100 nm or more. In the method of processing a stepped substrate having a pattern of the above-described height, filling and planarizing by forming a film of the composition for forming a resist underlayer film used in the inventive method for forming a resist underlayer film makes it possible to achieve a uniform film thickness in the subsequently formed silicon-containing resist middle layer film and resist upper layer film. Therefore, it is easy to ensure the exposure depth margin (DOF) at the time of photolithography, which is very desirable.

Furthermore, the present invention provides a patterning process by way of a four-layer resist process using such a method for forming a resist underlayer film, the patterning process including the steps of:
forming a resist underlayer film on a substrate to be processed by using the above-described method for forming a resist underlayer film;
forming an organic middle layer film on the resist underlayer film by using an organic middle layer film material;
forming a silicon-containing resist middle layer film on the organic middle layer film by using a silicon-containing resist middle layer film material;
if necessary, forming an organic antireflective film (BARC) or an adhesive film on the silicon-containing resist middle layer film;
forming a resist upper layer film on the silicon-containing resist middle layer film, on the BARC, or on the adhesive film by using a photoresist material;
subjecting the resist upper layer film to pattern exposure and then development with a developer, thereby forming a pattern in the resist upper layer film;
transferring the pattern to the BARC or to the adhesive film and the silicon-containing resist middle layer film by dry etching while using the resist upper layer film having the formed pattern as a mask;
transferring the pattern to the organic middle layer film by dry etching while using the silicon-containing resist middle layer film having the transferred pattern as a mask;
transferring the pattern to the resist underlayer film while using the organic middle layer film having the formed pattern as a mask; and
processing the substrate to be processed while using the resist underlayer film having the formed pattern as a mask, thereby forming the pattern in the substrate to be processed.

Furthermore, the present invention provides, as a patterning process by way of a four-layer resist process using such a method for forming a resist underlayer film, a patterning process for forming a pattern in a substrate to be processed, including the steps of:
(III-1) forming a resist underlayer film on a substrate to be processed by the above-described method for forming a resist underlayer film;
(III-2) forming an organic middle layer film on the resist underlayer film;
(III-3) forming a silicon-containing resist middle layer film or a combination of an inorganic hard mask middle layer film selected from the group consisting of a silicon oxide film, a silicon nitride film, and a silicon oxynitride film and an organic thin film on the organic middle layer film;
(III-4) forming a resist upper layer film on the silicon-containing resist middle layer film or the organic thin film by using a photoresist material;
(III-5) subjecting the resist upper layer film to pattern exposure and then development with a developer to form a pattern in the resist upper layer film;
(III-6) transferring the pattern to the silicon-containing resist middle layer film or the organic thin film and the inorganic hard mask middle layer film by dry etching while using the resist upper layer film having the formed pattern as a mask;
(III-7) transferring the pattern to the organic middle layer film by dry etching while using the silicon-containing resist middle layer film or the inorganic hard mask middle layer film having the transferred pattern as a mask;
(III-8) transferring the pattern to the resist underlayer film by dry etching while using the organic middle layer film having the transferred pattern as a mask; and
(III-9) processing the substrate to be processed while using the resist underlayer film having the formed pattern as a mask to form the pattern in the substrate to be processed.

As an organic middle layer film material that can be used for the organic middle layer film, it is possible to use: materials already known as materials for three-layer resist methods or materials for an underlayer film containing a silicon resist composition for two-layer resist methods; materials known as resist underlayer film materials for two-layer resist methods and three-layer resist methods, the materials including various resins, such as a 4,4'-(9-fluorenylidene)bisphenol novolak resin (molecular weight: 11,000) disclosed in JP2005-128509A, and also other novolak resins; etc. Furthermore, if it is desired for the resin to have a higher heat resistance than ordinary novolaks, a polycyclic skeleton can be introduced, as in a 6,6'-(9-fluorenylidene)-di(2-naphthol) novolak resin, and furthermore, a polyimide-based resin can also be selected (e.g., JP2004-153125A).

The organic middle layer film can be formed on the substrate to be processed by using a composition solution and by a spin-coating method or the like in the same manner as the photoresist composition. After forming the organic middle layer film by a spin-coating method or the like, it is desirable to bake the substrate in order to evaporate the organic solvent. The baking temperature is preferably 80 to 400°C, and the baking time is preferably 10 to 300 seconds.

Instead of the organic middle layer film, it is also possible to adopt an organic hard mask formed by a CVD method or an ALD method.

The organic middle layer film in the multilayer resist process described above exhibits etching resistance with respect to chlorine-based gas. Therefore, the dry etching of the resist underlayer film that is performed while using the organic middle layer film as a mask in the multilayer resist process is preferably performed using an etching gas mainly containing a chlorine-based gas.

### EXAMPLES

The present invention is more specifically described below with reference to Synthesis Examples, Comparative Synthesis Examples, Examples, and Comparative Examples. However, the present invention is not limited to these Examples.

### [Synthesis Example]

In the following Synthesis Examples, the following organic group starting material group G ((G1) to (G20)) and silicon-containing organic group starting material group H ((H1) to (H5)) were used.

The organic group starting material group G ((G1) to (G20)) is shown below.

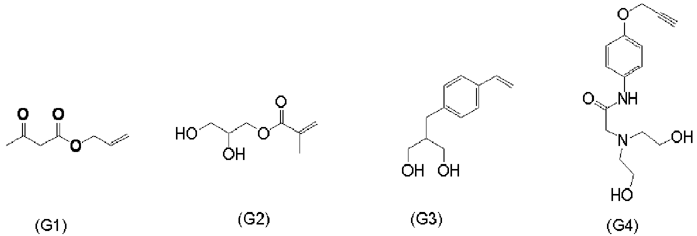

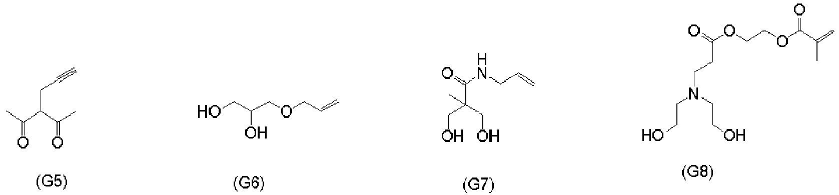

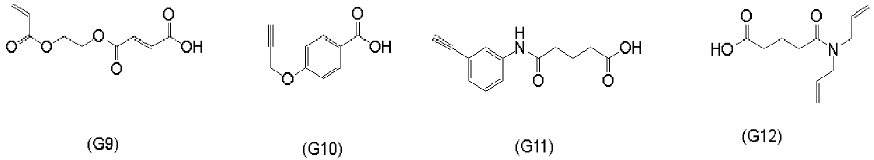

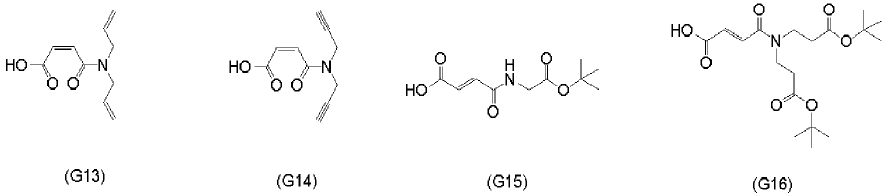

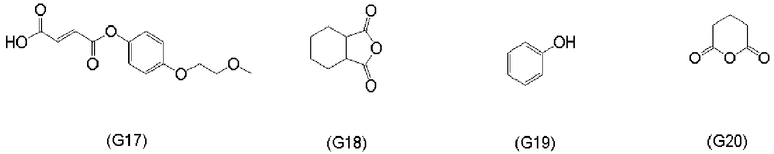

The silicon-containing organic group starting material group H ((H1) to (H5)) is shown below.

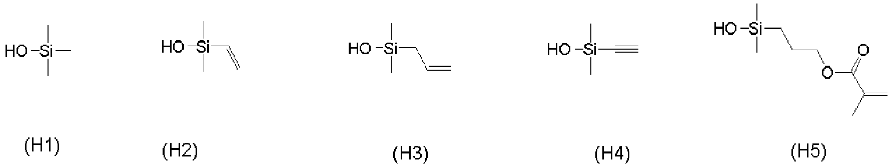

As a metal starting material M, the following metal compounds were used.
(M1): titanium tetraisopropoxide (377996 manufactured by Sigma-Aldrich Corp)
(M2): titanium butoxide tetramer (FUJIFILM Wako Pure Chemical Corporation)
(M3): Zr(OBu)₄: zirconium(IV)tetrabutoxide (80 mass% solution in 1-butanol) (Z0016 manufactured by Tokyo Chemical Industry Co., Ltd.)
(M4): Hf(OBu)₄: hafnium(IV)n-butoxide (667943 manufactured by Sigma-Aldrich Corp)
(M5): Ti(OBu)₄: tetrabutyl orthotitanate (B0742 manufactured by Tokyo Chemical Industry Co., Ltd.)
(M6): titanium(IV)diisopropoxybis(2,4-pentanedionate) (75 mass% solution in isopropyl alcohol) (B3395 manufactured by Tokyo Chemical Industry Co., Ltd.)

### [Synthesis Example 1] Synthesis of Compound (A-1) for Forming Resist Underlayer Film

Under a nitrogen atmosphere, an IPA solution (24.2 g) of deionized water (1.6 g) was agitated with an IPA solution (12.1 g) of a titanium tetraisopropoxide (M1) (33.4 g) and dropped at room temperature for 2 hours. The organic group starting material group (G1) (16.6 g) was added to a solution obtained and agitated at room temperature for 30 minutes. After the solution was concentrated under reduced pressure at 30°C, it was heated to 60°C and heating was continued under reduced pressure to generate no distillate. Then, a PGMEA/PGME (ratio by mass: 70/30) solution (69.0 g) was added thereto and heated under reduced pressure at 40°C until no IPA was distilled to obtain a PGMEA/PGME solution of a compound (A-1) for forming a resist underlayer film. The concentration of the components in the solution other than the solvent was 20 mass%.

### [Synthesis Examples 2 to 4] Synthesis of Compounds (A-2) to (A-4) for Forming Resist Underlayer Film

The compounds (A-2) to (A-4) for forming a resist underlayer film shown in Table 1 were obtained under the same reaction conditions as in Synthesis Example 1, except that the metal starting material M and the organic group starting material group G were used at the charging amounts shown in Table 1.

**[Table 1]**

| Synthesis Example | Metal starting material M | | Organic group starting material group G | | Compound for forming resist underlayer film |
|---|---|---|---|---|---|
| | Starting material | g | Starting material | g | |
| 1 | M1 | 33.4 | G1 | 16.6 | A-1 |
| 2 | M2 | 28.5 | G2 | 18.8 | A-2 |
| 3 | M3 | 56.3 | G3 | 22.6 | A-3 |
| 4 | M4 | 27.6 | G4 | 17.2 | A-4 |

### [Synthesis Example 5] Synthesis of Compound (A-5) for Forming Resist Underlayer Film

Under a nitrogen atmosphere, 11.8 g of tetrabutyl orthotitanate (M5) was dissolved in 20.6 g of a PGMEA/PGME (ratio by mass: 70/30) solution. The reaction temperature was raised to 50°C while stirring, and 6.5 g of the silicon-containing organic group starting material group (H1) was added dropwise to the solution. After the addition, stirring was continued for 2 hours at a reaction temperature of 60°C. Subsequently, a mixture obtained by suspending 4.8 g of the organic group starting material group (G5) in 8.6 g of a PGMEA/PGME (ratio by mass: 70/30) solution was added to the reaction system, and stirring was continued for 1 hour with the reaction temperature still at 60°C. After cooling to room temperature, the obtained reaction solution was filtered with a 0.45-µm PTFE filter. Thus, a solution of a compound (A-5) for forming a resist underlayer film in PGMEA/PGME was obtained. The concentration of the components in the solution other than the solvent was 23 mass%.

### [Synthesis Examples 6 to 20] Synthesis of Compounds (A-6) to (A-20) for Forming Resist Underlayer Film

The compounds (A-6) to (A-20) for forming a resist underlayer film shown in Table 2 were obtained under the same reaction conditions as in Synthesis Example 5, except that the metal starting material M, the organic group starting material group G, and the silicon-containing organic group starting material group H were used at the charging amounts shown in Table 2.

**[Table 2]**

| Synthesis Example | Metal starting material M | | Organic group starting material group G | | Silicon-containing organic group starting material group H | | Compound for forming resist underlayer film |
|---|---|---|---|---|---|---|---|
| | Starting material | g | Starting material | g | Starting material | g | |
| 5 | M5 | 11.8 | G5 | 4.8 | H1 | 6.5 | A-5 |
| 6 | M5 | 16.7 | G6 | 4.6 | H2 | 6.5 | A-6 |
| 7 | M5 | 16.7 | G7 | 7.3 | H3 | 7.2 | A-7 |
| 8 | M2 | 16.7 | G8 | 7.5 | H4 | 7.2 | A-8 |
| 9 | M3 | 16.7 | G9 | 11.9 | H1 | 6.5 | A-9 |
| 10 | M4 | 16.7 | G10 | 9.8 | H2 | 7.3 | A-10 |
| 11 | M3 | 16.7 | G11 | 15.2 | H1 | 6.5 | A-11 |
| 12 | M3 | 15.0 | G12 | 11.9 | H1 | 7.2 | A-12 |
| 13 | M3 | 19.8 | G13 | 13.0 | H2 | 9.9 | A-13 |
| 14 | M3 | 10.2 | G14 | 7.9 | H4 | 6.2 | A-14 |
| 15 | M3 | 13.3 | G15 | 14.7 | H1 | 6.1 | A-15 |
| 16 | M3 | 15.3 | G16 | 13.1 | H5 | 24.0 | A-16 |
| 17 | M3 | 13.5 | G17 | 14.8 | H2 | 7.3 | A-17 |
| 18 | M3 | 16.7 | G18 | 8.6 | H1 | 6.5 | A-18 |
| 19 | M3 | 16.7 | G19 | 6.0 | H1 | 5.9 | A-19 |
| 20 | M3 | 16.7 | G20 | 7.3 | H1 | 6.0 | A-20 |

### [Synthesis of Resin (R-1) for Forming Resist Underlayer Film for Comparative Example]

Under a nitrogen atmosphere, 160.2 g of 1,5-dihydroxynaphthalene, 56.8 g of formaldehyde, and 300 g of PGME (propylene glycol monomethyl ether) were added, and homogenized at an internal temperature of 100°C. After that, a mixed solution of 8.0 g of p-toluenesulfonic acid monohydrate and 8.0 g of PGME that had been mixed and homogenized beforehand was added dropwise slowly, and a reaction was allowed to take place at an internal temperature of 80°C for 8 hours. After the reaction was completed, the resultant was cooled to room temperature, and 2,000 ml of MIBK was added thereto. The resultant was washed six times with 500 ml of pure water, and the organic layer was evaporated under reduced pressure to dryness. After adding 300 g of THF to the residue to yield a homogeneous solution, a crystal was precipitated in 2,000 g of hexane. The precipitated crystal was separated by filtration, washed twice with 500 g of hexane, and collected. The collected crystal was vacuum-dried at 70°C, thereby obtaining a resin (R-1) for forming a resist underlayer film for a Comparative Example.

The weight-average molecular weight (Mw) and the dispersity (Mw/Mn) were determined by gel permeation chromatography (GPC) using tetrahydrofuran as an eluent, and the following results were obtained.
(R-1): Mw=3,300, Mw/Mn=2.54

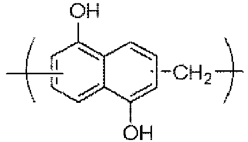

### [Preparation of Composition (UDL-1) for Forming Resist Underlayer Film]

The compound (A-1) for forming a resist underlayer film was dissolved at a ratio shown in Table 3 in a mixed solvent of propylene glycol monomethyl ether acetate (PGMEA) and propylene glycol monomethyl ether (PGME) containing 0.5 mass% of a surfactant FC-4430 (manufactured by Sumitomo 3M Limited), and the solution was filtered through a 0.02-µm membrane filter to prepare a composition (UDL-1) for forming a resist underlayer film.

### [Preparation of Compositions (UDL-2 to -20) for Forming Resist Underlayer Film and Composition (Comparative UDL-1) for Forming Resist Underlayer Film for Comparative Example]

Each composition was prepared in the same manner as UDL-1, except that the type and the contained amount of each compound were as shown in Table 3. In Table 3, "-" indicates that the component was not used. The following formula (F-1) was used for the acid generator (TAG).

### [Acid Generator]

The acid generator (F-1) used in the composition for forming a resist underlayer film is shown below.

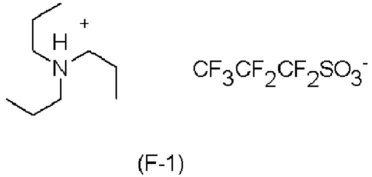

**[Table 3]**

| Composition for forming resist underlayer film | Compound for forming resist underlayer film | Additive | Solvent |
|---|---|---|---|
| | (parts by mass) | (parts by mass) | (parts by mass) |
| UDL-1 | A-1 (10) | - | PGMEA/PGME (60/30) |
| UDL-2 | A-2 (10) | F-1 (2) | PGMEA/PGME (60/30) |
| UDL-3 | A-3 (10) | - | PGMEA/PGME (60/30) |
| UDL-4 | A-4 (10) | - | PGMEA/PGME (60/30) |
| UDL-5 | A-5 (10) | - | PGMEA/PGME (60/30) |
| UDL-6 | A-6 (10) | - | PGMEA/PGME (60/30) |
| UDL-7 | A-7 (10) | - | PGMEA/PGME (60/30) |
| UDL-8 | A-8 (10) | - | PGMEA/PGME (60/30) |
| UDL-9 | A-9 (10) | - | PGMEA/PGME (60/30) |
| UDL-10 | A-10 (10) | - | PGMEA/PGME (60/30) |
| UDL-11 | A-11 (10) | - | PGMEA/PGME (60/30) |
| UDL-12 | A-12 (10) | - | PGMEA/PGME (60/30) |
| UDL-13 | A-13 (10) | - | PGMEA/PGME (60/30) |
| UDL-14 | A-14 (10) | - | PGMEA/PGME (60/30) |
| UDL-15 | A-15 (10) | - | PGMEA/PGME (60/30) |
| UDL-16 | A-16 (10) | - | PGMEA/PGME (60/30) |
| UDL-17 | A-17 (10) | F-1 (2) | PGMEA/PGME (60/30) |
| UDL-18 | A-18 (10) | - | PGMEA/PGME (60/30) |
| UDL-19 | A-19 (10) | - | PGMEA/PGME (60/30) |
| UDL-20 | A-20 (10) | - | PGMEA/PGME (60/30) |
| Comparative UDL-1 | R-1 (10) | - | PGMEA (90) |

### [Filling Property Evaluation (Examples 1-1 to 1-17 and Comparative Examples 1-1 to 1-2)]

Each of the compositions (UDL-1 to -17 and comparative UDL-1) prepared above was respectively applied onto an SiO₂ wafer substrate having a dense line-and-space pattern (line width = 60 nm, line depth = 100 nm, distance between the centers of two adjacent lines 120 nm), followed by heating by using a hot plate at 350°C for 60 seconds. Then, under a nitrogen atmosphere (oxygen concentration: 0.01 volume %), the substrate was heated at 500°C for 60 seconds. Thus, a resist underlayer film having a film thickness of 80 nm was formed.

Meanwhile, in Comparative Example 1-2, a resist underlayer film was formed by heating under an air atmosphere at 500°C for 60 seconds.

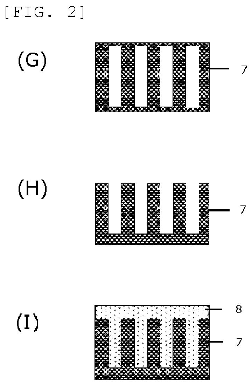

The substrate used was a base substrate 7 (SiO₂ wafer substrate) having a dense line-and-space pattern shown in FIG. 2(G) (downward view) and (H) (cross-sectional view). In the filling property evaluation, the cross-sectional shape of each of the obtained wafer substrates was observed using an electron microscope (S-4700: manufactured by Hitachi, Ltd.), and the presence/absence of voids (gaps) inside the resist underlayer film filling the space between the lines was confirmed. Table 4 shows the results. In this evaluation, when a composition for forming a resist underlayer film having a poor filling property is used, voids are generated inside the resist underlayer film filling the space between the lines. In this evaluation, when a composition for forming a resist underlayer film having a desirable filling property is used, as shown in FIG. 2(I), the inside of the resist underlayer film filling the space between the lines of the base substrate 7 having the dense line-and-space pattern is filled with a void-free resist underlayer film 8.

**[Table 4]**

| Example | Composition for forming resist underlayer film | Heating temperature when forming resist underlayer film | Oxygen concentration | Filling property |
|---|---|---|---|---|
| | | | Volume % | Voids |
| Example 1-1 | UDL-1 | 500°C | 0.01 | Absent |
| Example 1-2 | UDL-2 | 500°C | 0.01 | Absent |
| Example 1-3 | UDL-3 | 500°C | 0.01 | Absent |
| Example 1-4 | UDL-4 | 500°C | 0.01 | Absent |
| Example 1-5 | UDL-5 | 500°C | 0.01 | Absent |
| Example 1-6 | UDL-6 | 500°C | 0.01 | Absent |
| Example 1-7 | UDL-7 | 500°C | 0.01 | Absent |
| Example 1-8 | UDL-8 | 500°C | 0.01 | Absent |
| Example 1-9 | UDL-9 | 500°C | 0.01 | Absent |
| Example 1-10 | UDL-10 | 500°C | 0.01 | Absent |
| Example 1-11 | UDL-11 | 500°C | 0.01 | Absent |
| Example 1-12 | UDL-12 | 500°C | 0.01 | Absent |
| Example 1-13 | UDL-13 | 500°C | 0.01 | Absent |
| Example 1-14 | UDL-14 | 500°C | 0.01 | Absent |
| Example 1-15 | UDL-15 | 500°C | 0.01 | Absent |
| Example 1-16 | UDL-16 | 500°C | 0.01 | Absent |
| Example 1-17 | UDL-17 | 500°C | 0.01 | Absent |
| Comparative Example 1-1 | Comparative UDL-1 | 500°C | 0.01 | Absent |
| Comparative Example 1-2 | UDL-1 | 500°C | 20 | Present |

It was successfully confirmed that, as shown in Table 4, in Examples 1-1 to 1-17, using the inventive method for forming a resist underlayer film, controlling the oxygen concentration made it possible to fill the dense line-and-space pattern without the generation of voids even after baking at 500°C, and excellent filling property was provided even under high-temperature baking conditions.

In Comparative Example 1-2, where the resist underlayer film was formed by heating under an air atmosphere at 500°C for 60 seconds, voids were observed at the bottom of the pattern. Even when the composition UDL-1 for forming a resist underlayer film, containing the compound (A-1) for forming a resist underlayer film, the compound having an organic crosslinking group, is used, volume shrinkage due to high-temperature baking in an air atmosphere is great. Therefore, this case can be said to be unfavorable from the viewpoint of filling property.

### [Etching Resistance Evaluation (Examples 2-1 to 2-20 and Comparative Example 2-1)]

Each of the compositions (UDL-1 to -20 and comparative UDL-1) for forming a resist underlayer film was respectively applied onto a silicon substrate and heated by using a hot plate at 350°C for 60 seconds to form a resist underlayer film having a film thickness of 80 nm (film thickness "a"). In addition, separately from the above evaluation, a substrate coated with the composition and heated at 350°C for 60 seconds was further heated at 500°C for 60 seconds under a nitrogen atmosphere (oxygen concentration: 0.01 volume %) to form a resist underlayer film having a film thickness of 80 nm (film thickness "a").

Subsequently, etching was performed with CF₄ gas under the following conditions by using an etching apparatus CE-300I manufactured by ULVAC, Inc., and the film thickness "b" was measured. Then, the film thickness etched in 1 minute was calculated as an etching rate (nm/min) from the film thickness etched (film thickness "a" - film thickness "b") using each gas in a specified time. Table 5 shows the results.

Conditions of dry etching with CF₄ gas
Pressure: 1 Pa
Antenna RF power: 100 W
Bias RF power: 15 W
CF₄ gas flow rate: 15 sccm
Time: 30 sec

**[Table 5]**

| Example | Composition for forming resist underlayer film | Etching resistance (a) | Etching resistance (b) | Improvement rate |
|---|---|---|---|---|
| | | 350°C | 500°C | [(a-b)/a]% |
| Example 2-1 | UDL-1 | 14 | 7 | 50% |
| Example 2-2 | UDL-2 | 16 | 8 | 50% |
| Example 2-3 | UDL-3 | 15 | 8 | 47% |
| Example 2-4 | UDL-4 | 16 | 9 | 44% |
| Example 2-5 | UDL-5 | 18 | 9 | 50% |
| Example 2-6 | UDL-6 | 19 | 10 | 47% |
| Example 2-7 | UDL-7 | 20 | 10 | 50% |
| Example 2-8 | UDL-8 | 24 | 12 | 50% |
| Example 2-9 | UDL-9 | 28 | 14 | 50% |
| Example 2-10 | UDL-10 | 30 | 14 | 53% |
| Example 2-11 | UDL-11 | 26 | 12 | 54% |
| Example 2-12 | UDL-12 | 33 | 14 | 58% |
| Example 2-13 | UDL-13 | 29 | 9 | 69% |
| Example 2-14 | UDL-14 | 30 | 8 | 73% |
| Example 2-15 | UDL-15 | 24 | 10 | 58% |
| Example 2-16 | UDL-16 | 25 | 12 | 52% |
| Example 2-17 | UDL-17 | 27 | 13 | 52% |
| Example 2-18 | UDL-18 | 23 | 17 | 26% |
| Example 2-19 | UDL-19 | 17 | 12 | 29% |
| Example 2-20 | UDL-20 | 26 | 18 | 31% |
| Comparative Example 2-1 | Comparative UDL-1 | 65 | 57 | 12% |

As shown in Table 5, it was observed that considerably better etching resistance to CF₄ gas was exhibited in Examples 2-1 to 2-20, where the inventive method for forming a resist underlayer film was used, than in Comparative Example 2-1, where comparative UDL-1, which was a composition for forming a resist underlayer film for the Comparative Example and contained the resin (R-1) for forming a resist underlayer film for the Comparative Example, was used. In addition, the result that etching resistance is improved by high-temperature baking with controlled oxygen concentration was achieved. Also achieved was the result that the rate of improvement of the etching resistance due to the baking at 500°C was higher in Examples 2-1 to 2-17, where UDL-1 to UDL-17, which are compositions for forming a resist underlayer film containing the compounds (A-1) to (A-17) for forming a resist underlayer film containing an organic crosslinking group, were used, than in Examples 2-18 to 2-20, where UDL-18 to -20, which are compositions for forming a resist underlayer film containing compounds for forming a resist underlayer film containing no organic crosslinking groups, were used. The cause of this result is not certain, but there is a possibility that organic crosslinking components in the resist underlayer film are cleaved and re-crosslinked by the high-temperature baking, and densification of the film occurs.

### [Patterning Process (Examples 3-1 to 3-17 and Comparative Example 3-1)]

Each of the compositions (UDL-1 to -17 and comparative UDL-1) for forming a resist underlayer film was respectively applied onto an SiO₂ wafer substrate, baked in the atmosphere at 350°C for 60 seconds, and then baked at an oxygen concentration of 0.01 volume % at 500°C for 60 seconds to form a resist underlayer film having a thickness of 80 nm. A silicon-containing resist middle layer film material (SOG-1) was applied thereto, followed by baking at 220°C for 60 seconds to form a resist middle layer film having a thickness of 50 nm. A monolayer resist for ArF as a resist upper layer film material was applied thereto, followed by baking at 105°C for 60 seconds to form a photoresist film having a thickness of 100 nm. A liquid immersion top coat composition (TC-1) was applied to the photoresist film, followed by baking at 90°C for 60 seconds to form a top coat having a thickness of 50 nm.

The silicon-containing resist middle layer film material (SOG-1) was prepared by dissolving a polymer represented by an ArF silicon-containing middle layer film polymer (SiP1) and a thermal crosslinking catalyst (CAT1) in an organic solvent containing 0.1 mass% of FC-4430 (manufactured by Sumitomo 3M Limited) in the proportion shown in Table 6; and filtering the solution through a filter made of a fluororesin and having a pore size of 0.1 µm.

**[Table 6]**

| | Polymer | Thermal crosslinking catalyst | Organic solvent |
|---|---|---|---|
| | (parts by mass) | (parts by mass) | (parts by mass) |
| SOG-1 | SiP1 (100) | CAT1 (1) | Propylene glycol monoethyl ether (4,000) |

The structural formulae of the used ArF silicon-containing middle layer film polymer (SiP1) and thermal crosslinking catalyst (CAT1) are shown below.

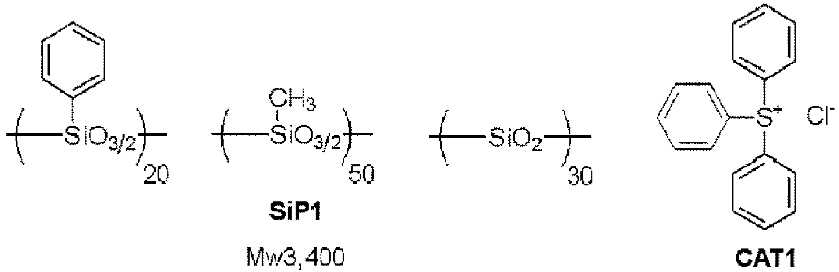

The resist upper layer film material (monolayer resist for ArF) was prepared by dissolving a polymer (RP1), an acid generator (PAG1), and a basic compound (Amine1), each in the proportion shown in Table 7, in a solvent containing 0.1% by mass of a surfactant (FC-4430: manufactured by Sumitomo 3M Limited), and filtering the solution through a 0.1-pm filter made of a fluororesin.

**[Table 7]**

| | Polymer (parts by mass) | Acid generator (parts by mass) | Basic compound (parts by mass) | Solvent (parts by mass) |
|---|---|---|---|---|
| Monolayer resist for ArF | RP1 (100) | PAG1 (6.6) | Amine1 (0.8) | PGMEA (2, 500) |

The polymer (RP1), the acid generator (PAG1), and the basic compound (Amine1) used for the resist upper layer film material (monolayer resist for ArF) are shown below.

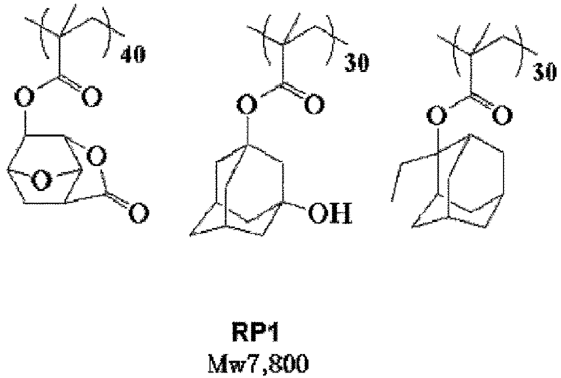

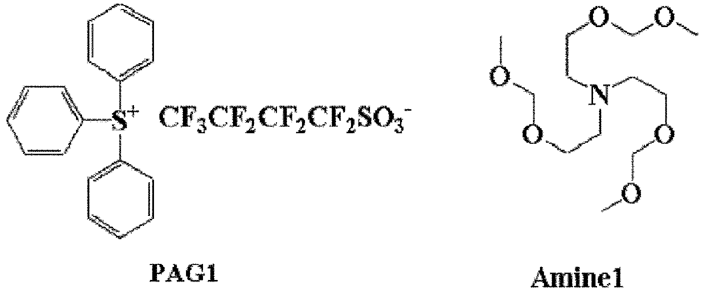

The liquid immersion top coat composition (TC-1) was prepared by dissolving a top coat polymer (PP1) in an organic solvent at the proportion shown in Table 8, and filtering the solution through a 0.1-pm filter made of a fluororesin.

**[Table 8]**

| | Top coat polymer (parts by mass) | Organic solvent (parts by mass) |
|---|---|---|
| TC-1 | PP1 (100) | Diisoamyl ether (2,700) 2-methyl-1-butanol (270) |

The top coat polymer (PP1) used for the liquid immersion top coat composition (TC-1) is shown below.

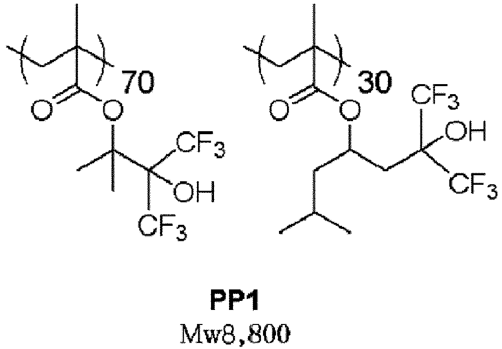

Then, the substrate was exposed to light with an ArF liquid immersion exposure apparatus (NSR-S610C manufactured by Nikon Corporation, NA: 1.30, σ: 0.98/0.65, 35° s-polarized dipole illumination, 6% halftone phase shift mask), baked at 100°C for 60 seconds (PEB), and developed with a 2.38% by mass aqueous solution of tetramethylammonium hydroxide (TMAH) for 30 seconds, thereby obtaining a 55 nm 1:1 positive line-and-space pattern (a resist upper layer film pattern).

Subsequently, the resist middle layer film was etched by dry etching while using the resist upper layer film pattern as a mask to form a hard mask pattern. A resist underlayer film was then etched while using the obtained hard mask pattern as a mask to form a resist underlayer film pattern, and the SiO₂ film was etched while using the obtained resist underlayer film pattern as a mask. The etching conditions were as follows.
Conditions in transferring resist upper layer film pattern to resist middle layer film
Conditions of dry etching with CF₄ gas
   Pressure: 1 Pa
   Antenna RF power: 100 W
   Bias RF power: 15 W
   CF₄ gas flow rate: 15 sccm
   Time: 60 sec
Conditions in transferring hard mask pattern to resist underlayer film
Conditions of dry etching with Cl₂ gas
   Pressure: 1 Pa
   Antenna RF power: 320 W
   Bias RF power: 30 W
   Cl₂ gas flow rate: 25 sccm
   Time: 45 sec
Conditions in transferring resist underlayer film pattern to SiO₂ film
Conditions of dry etching with CF₄ gas
   Pressure: 1 Pa
   Antenna RF power: 100 W
   Bias RF power: 15 W
   CF₄ gas flow rate: 15 sccm
   Time: 60 sec

Table 9 shows the results obtained by observation of the pattern cross section with an electron microscope (S-4700) manufactured by Hitachi, Ltd.

**[Table 9]**

| Example | Composition for forming resist underlayer film | Patterning process |
|---|---|---|
| | | Pattern profile |
| Example 3-1 | UDL-1 | Vertical profile |
| Example 3-2 | UDL-2 | Vertical profile |
| Example 3-3 | UDL-3 | Vertical profile |
| Example 3-4 | UDL-4 | Vertical profile |
| Example 3-5 | UDL-5 | Vertical profile |
| Example 3-6 | UDL-6 | Vertical profile |
| Example 3-7 | UDL-7 | Vertical profile |
| Example 3-8 | UDL-8 | Vertical profile |
| Example 3-9 | UDL-9 | Vertical profile |
| Example 3-10 | UDL-10 | Vertical profile |
| Example 3-11 | UDL-11 | Vertical profile |
| Example 3-12 | UDL-12 | Vertical profile |
| Example 3-13 | UDL-13 | Vertical profile |
| Example 3-14 | UDL-14 | Vertical profile |
| Example 3-15 | UDL-15 | Vertical profile |
| Example 3-16 | UDL-16 | Vertical profile |
| Example 3-17 | UDL-17 | Vertical profile |
| Comparative Example 3-1 | Comparative UDL-1 | Distorted pattern |

As shown in Table 9, in the inventive patterning processes (Examples 3-1 to 3-17), the resist upper layer film pattern was successfully transferred to the substrate in the end in every case, and it was confirmed that the patterning processes can be used suitably for fine processing using a multilayer resist method. On the other hand, in Comparative Example 3-1, using comparative UDL-1 found to exhibit insufficient performance in the dry etching resistance evaluation, distortion of the pattern profile occurred at the time of pattern processing, and it was not possible to obtain a favorable pattern in the end.

From the above, the inventive methods for forming a resist underlayer film and patterning processes are particularly suitably employed in a multilayer resist process including the filling and planarization of a substrate to be processed having steps or unevenness, and are extremely useful in fine patterning for manufacturing semiconductor devices.

The present description includes the following embodiments.
[1]: A method for forming a resist underlayer film, comprising:
   a coating step of coating a substrate with a composition for forming a resist underlayer film containing a metal compound having a metal-oxygen covalent bond and an organic solvent; and
   a heating step of heating the coated substrate in an atmosphere having an oxygen concentration of less than 1 volume % at a temperature of 450°C or higher and 800°C or lower, wherein
   a compound containing at least one crosslinking group represented by the following general formulae (a-1) to (a-4), (b-1) to (b-4), and (c-1) to (c-3) is used as the metal compound, 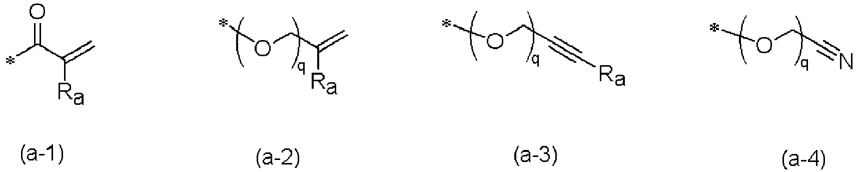 wherein Rₐ represents a hydrogen atom or a monovalent organic group having 1 to 10 carbon atoms, "q" represents 0 or 1, and "*" represents an attachment point, 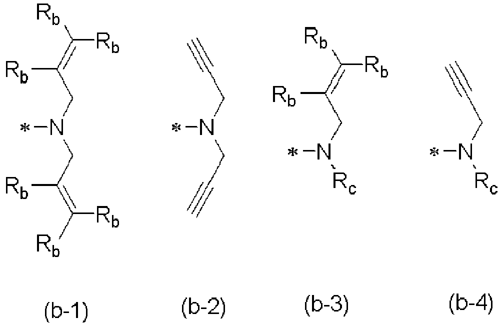 wherein R_{b}s represent a hydrogen atom or a methyl group and are identical to or different from each other in a single formula, R_{c} represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms, and "*" represents an attachment point, 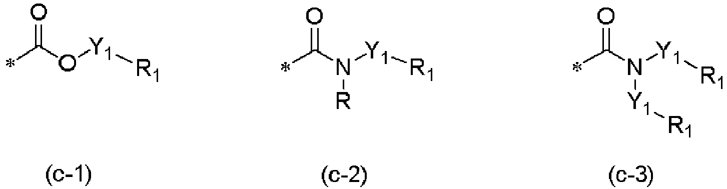 wherein Y₁ represents a divalent organic group having 1 to 20 carbon atoms, R represents a hydrogen atom, a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms, R₁ represents an organic group whose protecting group is to be removed by an action of an acid, heat, or both to generate one or more hydroxy groups or carboxy groups, R₁ being represented by one of the following general formulae (1), and "*" represents an attachment point, 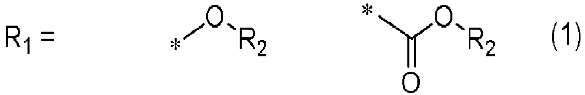 wherein R₂ represents an organic group whose protecting group is to be removed by an action of an acid, heat, or both, and "*" represents an attachment point to Y₁.
[2]: The method for forming a resist underlayer film of the above [1], wherein the oxygen concentration is set to 0.1 volume % or less.
[3]: The method for forming a resist underlayer film of the above [1] or [2], wherein the temperature is set to 500°C or higher and 600°C or lower.
[4]: The method for forming a resist underlayer film of any one of the above [1] to [3], wherein the metal contained in the metal compound is titanium, zirconium, hafnium, or a combination thereof.
[5]: The method for forming a resist underlayer film of any one of the above [1] to [4], wherein a compound containing a ligand derived from a silicon compound represented by the following general formula (2) is further used as the metal compound, 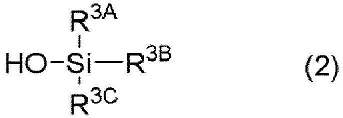 wherein R^{3A}, R^{3B}, and R^{3C} each represent any organic group selected from an organic group having 2 to 30 carbon atoms and having any crosslinking group of a structure represented by the following general formulae (d-1) to (d-3), a substituted or unsubstituted alkyl group having 1 to 20 carbon atoms, and an aryl group having 6 to 20 carbon atoms, 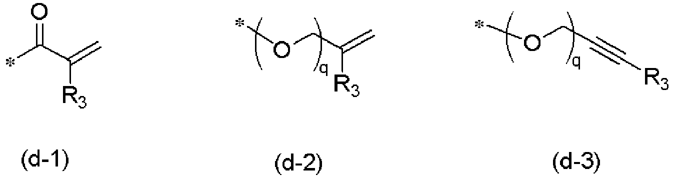 wherein R₃ represents a hydrogen atom or a monovalent organic group having 1 to 10 carbon atoms, "q" represents 0 or 1, and *"***"* represents an attachment point.
[6]: A patterning process for forming a pattern in a substrate to be processed, comprising the steps of:
   (I-1) forming a resist underlayer film on a substrate to be processed by the method for forming a resist underlayer film of any one of the above [1] to [5] ;
   (I-2) forming a silicon-containing resist middle layer film on the resist underlayer film;
   (I-3) forming a resist upper layer film on the silicon-containing resist middle layer film by using a photoresist material;
   (I-4) subjecting the resist upper layer film to pattern exposure and then development with a developer to form a pattern in the resist upper layer film;
   (I-5) transferring the pattern to the silicon-containing resist middle layer film by dry etching while using the resist upper layer film having the formed pattern as a mask;
   (I-6) transferring the pattern to the resist underlayer film by dry etching while using the silicon-containing resist middle layer film having the transferred pattern as a mask; and
   (I-7) processing the substrate to be processed while using the resist underlayer film having the formed pattern as a mask to form the pattern in the substrate to be processed.
[7]: A patterning process for forming a pattern in a substrate to be processed, comprising the steps of:
   (II-1) forming a resist underlayer film on a substrate to be processed by the method for forming a resist underlayer film of any one of the above [1] to [5];
   (II-2) forming an inorganic hard mask middle layer film selected from the group consisting of a silicon oxide film, a silicon nitride film, and a silicon oxynitride film on the resist underlayer film;
   (II-3) forming an organic thin film on the inorganic hard mask middle layer film;
   (II-4) forming a resist upper layer film on the organic thin film by using a photoresist material;
   (II-5) subjecting the resist upper layer film to pattern exposure and then development with a developer to form a pattern in the resist upper layer film;
   (II-6) transferring the pattern to the organic thin film and the inorganic hard mask middle layer film by dry etching while using the resist upper layer film having the formed pattern as a mask;
   (II-7) transferring the pattern to the resist underlayer film by dry etching while using the inorganic hard mask middle layer film having the transferred pattern as a mask; and
   (II-8) processing the substrate to be processed while using the resist underlayer film having the formed pattern as a mask to form the pattern in the substrate to be processed.
[8]: A patterning process for forming a pattern in a substrate to be processed, comprising the steps of:
   (III-1) forming a resist underlayer film on a substrate to be processed by the method for forming a resist underlayer film of any one of the above [1] to [5];
   (III-2) forming an organic middle layer film on the resist underlayer film;
   (III-3) forming a silicon-containing resist middle layer film or a combination of an inorganic hard mask middle layer film selected from the group consisting of a silicon oxide film, a silicon nitride film, and a silicon oxynitride film and an organic thin film on the organic middle layer film;
   (III-4) forming a resist upper layer film on the silicon-containing resist middle layer film or the organic thin film by using a photoresist material;
   (III-5) subjecting the resist upper layer film to pattern exposure and then development with a developer to form a pattern in the resist upper layer film;
   (III-6) transferring the pattern to the silicon-containing resist middle layer film or the organic thin film and the inorganic hard mask middle layer film by dry etching while using the resist upper layer film having the formed pattern as a mask;
   (III-7) transferring the pattern to the organic middle layer film by dry etching while using the silicon-containing resist middle layer film or the inorganic hard mask middle layer film having the transferred pattern as a mask;
   (III-8) transferring the pattern to the resist underlayer film by dry etching while using the organic middle layer film having the transferred pattern as a mask; and
   (III-9) processing the substrate to be processed while using the resist underlayer film having the formed pattern as a mask to form the pattern in the substrate to be processed.
[9]: A method for forming a resist underlayer film, comprising:
   a coating step of coating a substrate with a composition for forming a resist underlayer film containing a metal belonging to the third period to the seventh period and the group III to the group XV of the periodic table; and
   a heating step of heating the coated substrate in an atmosphere having an oxygen concentration of less than 1 volume % at a temperature of 450°C or higher and 800°C or lower.
[10]: The method for forming a resist underlayer film of the above [9], wherein a composition containing a metal compound having a metal-oxygen covalent bond or containing a metal compound having a metal-carbon covalent bond is used as the composition for forming a resist underlayer film.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for forming a resist underlayer film, comprising:
a coating step of coating a substrate with a composition for forming a resist underlayer film containing a metal compound having a metal-oxygen covalent bond and an organic solvent; and
a heating step of heating the coated substrate in an atmosphere having an oxygen concentration of less than 1 volume % at a temperature of 450°C or higher and 800°C or lower, wherein
a compound containing at least one crosslinking group represented by the following general formulae (a-1) to (a-4), (b-1) to (b-4), and (c-1) to (c-3) is used as the metal compound, 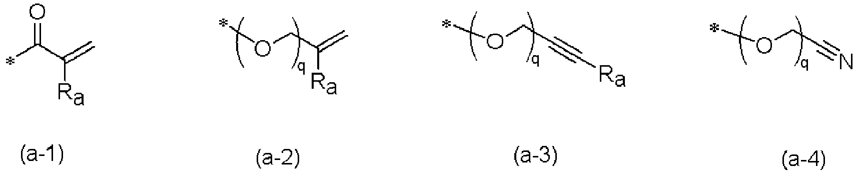 wherein Rₐ represents a hydrogen atom or a monovalent organic group having 1 to 10 carbon atoms, "q" represents 0 or 1, and "*" represents an attachment point, 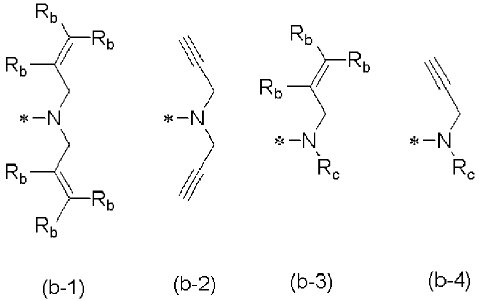 wherein R_{b}s represent a hydrogen atom or a methyl group and are identical to or different from each other in a single formula, R_{c} represents a hydrogen atom, a substituted or unsubstituted saturated or unsaturated monovalent organic group having 1 to 20 carbon atoms, a substituted or unsubstituted aryl group having 6 to 30 carbon atoms, or a substituted or unsubstituted arylalkyl group having 7 to 31 carbon atoms, and "*" represents an attachment point, 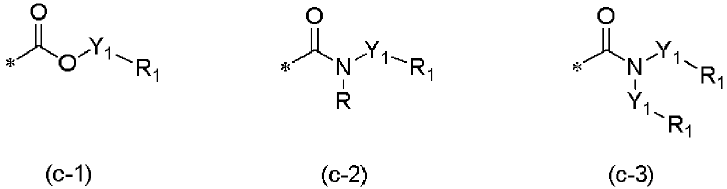 wherein Y₁ represents a divalent organic group having 1 to 20 carbon atoms, R represents a hydrogen atom, a substituted or unsubstituted saturated divalent organic group having 1 to 20 carbon atoms, a substituted or unsubstituted unsaturated divalent organic group having 2 to 20 carbon atoms, a substituted or unsubstituted aryl group having 6 to 30 carbon atoms, or a substituted or unsubstituted arylalkyl group having 7 to 31 carbon atoms, R₁ represents an organic group whose protecting group is to be removed by an action of an acid, heat, or both to generate one or more hydroxy groups or carboxy groups, R₁ being represented by one of the following general formulae (1), and "*" represents an attachment point, 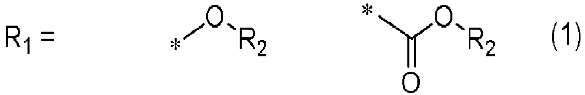 wherein R₂ represents an organic group whose protecting group is to be removed by an action of an acid, heat, or both, and "*" represents an attachment point to Y₁.

2. The method for forming a resist underlayer film according to claim 1, wherein the oxygen concentration is set to 0.1 volume % or less.

3. The method for forming a resist underlayer film according to claim 1 or 2, wherein the temperature is set to 500°C or higher and 600°C or lower.

4. The method for forming a resist underlayer film according to any one of claims 1 to 3, wherein the metal contained in the metal compound is titanium, zirconium, hafnium, or a combination thereof.

5. The method for forming a resist underlayer film according to any one of claims 1 to 4, wherein a compound containing a ligand derived from a silicon compound represented by the following general formula (2) is further used as the metal compound, 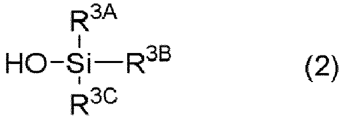 wherein R^{3A}, R^{3B}, and R^{3C} each represent any organic group selected from an organic group having 2 to 30 carbon atoms and having any crosslinking group of a structure represented by the following general formulae (d-1) to (d-3), a substituted or unsubstituted alkyl group having 1 to 20 carbon atoms, and an aryl group having 6 to 20 carbon atoms, 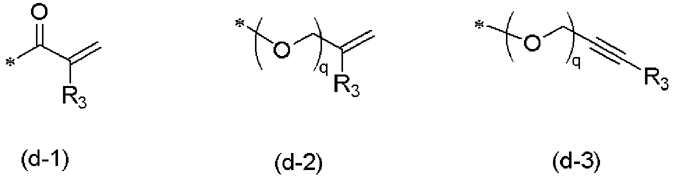 wherein R₃ represents a hydrogen atom or a monovalent organic group having 1 to 10 carbon atoms, "q" represents 0 or 1, and "*" represents an attachment point.

6. A patterning process for forming a pattern in a substrate to be processed, comprising the steps of:
(I-1) forming a resist underlayer film on a substrate to be processed by the method for forming a resist underlayer film according to any one of claims 1 to 5;
(I-2) forming a silicon-containing resist middle layer film on the resist underlayer film;
(I-3) forming a resist upper layer film on the silicon-containing resist middle layer film by using a photoresist material;
(I-4) subjecting the resist upper layer film to pattern exposure and then development with a developer to form a pattern in the resist upper layer film;
(I-5) transferring the pattern to the silicon-containing resist middle layer film by dry etching while using the resist upper layer film having the formed pattern as a mask;
(I-6) transferring the pattern to the resist underlayer film by dry etching while using the silicon-containing resist middle layer film having the transferred pattern as a mask; and
(I-7) processing the substrate to be processed while using the resist underlayer film having the formed pattern as a mask to form the pattern in the substrate to be processed.

7. A patterning process for forming a pattern in a substrate to be processed, comprising the steps of:
(II-1) forming a resist underlayer film on a substrate to be processed by the method for forming a resist underlayer film according to any one of claims 1 to 5;
(II-2) forming an inorganic hard mask middle layer film selected from the group consisting of a silicon oxide film, a silicon nitride film, and a silicon oxynitride film on the resist underlayer film;
(II-3) forming an organic thin film on the inorganic hard mask middle layer film;
(II-4) forming a resist upper layer film on the organic thin film by using a photoresist material;
(II-5) subjecting the resist upper layer film to pattern exposure and then development with a developer to form a pattern in the resist upper layer film;
(II-6) transferring the pattern to the organic thin film and the inorganic hard mask middle layer film by dry etching while using the resist upper layer film having the formed pattern as a mask;
(II-7) transferring the pattern to the resist underlayer film by dry etching while using the inorganic hard mask middle layer film having the transferred pattern as a mask; and
(II-8) processing the substrate to be processed while using the resist underlayer film having the formed pattern as a mask to form the pattern in the substrate to be processed.

8. A patterning process for forming a pattern in a substrate to be processed, comprising the steps of:
(III-1) forming a resist underlayer film on a substrate to be processed by the method for forming a resist underlayer film according to any one of claims 1 to 5;
(III-2) forming an organic middle layer film on the resist underlayer film;
(III-3) forming a silicon-containing resist middle layer film or a combination of an inorganic hard mask middle layer film selected from the group consisting of a silicon oxide film, a silicon nitride film, and a silicon oxynitride film and an organic thin film on the organic middle layer film;
(III-4) forming a resist upper layer film on the silicon-containing resist middle layer film or the organic thin film by using a photoresist material;
(III-5) subjecting the resist upper layer film to pattern exposure and then development with a developer to form a pattern in the resist upper layer film;
(III-6) transferring the pattern to the silicon-containing resist middle layer film or the organic thin film and the inorganic hard mask middle layer film by dry etching while using the resist upper layer film having the formed pattern as a mask;
(III-7) transferring the pattern to the organic middle layer film by dry etching while using the silicon-containing resist middle layer film or the inorganic hard mask middle layer film having the transferred pattern as a mask;
(III-8) transferring the pattern to the resist underlayer film by dry etching while using the organic middle layer film having the transferred pattern as a mask; and
(III-9) processing the substrate to be processed while using the resist underlayer film having the formed pattern as a mask to form the pattern in the substrate to be processed.

9. A method for forming a resist underlayer film, comprising:
a coating step of coating a substrate with a composition for forming a resist underlayer film containing a metal belonging to the third period to the seventh period and the group III to the group XV of the periodic table; and
a heating step of heating the coated substrate in an atmosphere having an oxygen concentration of less than 1 volume % at a temperature of 450°C or higher and 800°C or lower.

10. The method for forming a resist underlayer film according to claim 9, wherein a composition containing a metal compound having a metal-oxygen covalent bond or containing a metal compound having a metal-carbon covalent bond is used as the composition for forming a resist underlayer film.
